Europäisches Patentamt

European Patent Office

Office européen des brevets

(11) Numéro de publication: **0 006 983**
**B1**

# (12) FASCICULE DE BREVET EUROPEEN

(45) Date de publication du fascicule de brevet: **16.09.81**

(51) Int. Cl.³: **H 01 L 29/82,**
**H 01 L 29/90, G 01 R 33/06**

(21) Numéro de dépôt: **79101388.1**

(22) Date de dépôt: **07.05.79**

(54) **Transistor à tension d'avalanche commandée pouvant être sensible à un champ magnétique.**

(30) Priorité: **13.07.78 US 924489**

(43) Date de publication de la demande:
**23.01.80 Bulletin 80/2**

(45) Mention de la délivrance du brevet:
**16.09.81 Bulletin 81/37**

(84) Etats Contractants Désignés:
**BE CH DE FR GB NL SE**

(56) Documents cités:
**US - A - 3 714 523**
**US - A - 3 714 559**

**IBM TECHNICAL DISCLOSURE BULLETIN,**
**vol. 18, no. 5, octobre 1975,**
**New York, US,**
**L. B. FREEMAN et al.: "Semiconductor**
**magnetic field sensor", pages 1389—1390**

(73) Titulaire: **International Business Machines**
**Corporation**
**Armonk, N.Y. 10504 (US)**

(72) Inventeur: **Vinal, Albert Watson**
**810 Queensferry Road**
**Cary NC 27511 (US)**

(74) Mandataire: **Gallois, Gerard**
**COMPAGNIE IBM FRANCE Département de**
**Propriété Industrielle**
**F-06610 - La Gaude (FR)**

Courier Press, Leamington Spa, England.

Transistor à tension d'avalanche commandée pouvant être sensible à un champ magnétique

DESCRIPTION
Domaine Technique
La présente invention se rapporte à un transistor selon le préambule de la revendication 1 et à un mode particulier de réalisation de ce transistor, sensible à un champ magnétique perpendiculaire au plan de la surface de son corps semi-conducteur.

Etat de la technique antérieure
Un transistor selon le préambule de la revendication 1 est connu par le brevet US - A - 3 714 559. Ce transistor connu comporte, pour être sensible à un champ magnétique, au moins deux drains, ces drains étant séparés l'un de l'autre d'une distance qui est inférieure à la distance qui les sépare de la source ces drains étant disposés symétriquement par rapport à une ligne qui joint le milieu de la distance les séparant au centre de la source, cette ligne définissant une ligne centrale d'une zone conductrice qui s'étend à partir de la source jusqu'aux drains.

Le claquage par avalanche est un terme général descriptif d'un processus appelé ionisation par impact qui se produit dans les dispositifs à semi-conducteur. Diverses structures de transistors présentent des tensions et modes de claquage caractéristiques. Cependant, la tendance générale, à l'exception des diodes à claquage de Zener, est d'éviter la création de tensions de claquage ou d'ionisation dans les dispositifs à semi-conducteur. Le claquage du type général décrit doit habituellement être évité du fait qu'il engendre un bruit, une instabilité et des conditions de fonctionnement non linéaires. Comme on le démontrera cependant, de tels effets peuvent être contrôlés ou supprimés.

On connaît également un certain nombre de détecteurs magnétiques à semi-conducteur. Il n'existe pas, cependant, actuellement, de détecteurs magnétiques connus qui utilisent un processus d'avalanche ou d'ionisation pour créer une tension de sortie magnétiquement variable.

Compte tenu de la technique antérieure ci-dessus mentionnée, l'objet de la présente invention telle qu'elle est caractérisée dans les revendications 1 à 8 est de réaliser une catégorie perfectionnée de structures de transistors dans lesquelles une condition de tension d'ionisation ou de claquage par avalanche commandée peut être créée et entretenue d'une manière stable.

L'objet de la présente invention pourra être réalisé, dans un transistor à claquage par avalanche, à l'aide de moyens perfectionnés pour créer et commander les processus d'ionisation par impact.

L'objet de la présente invention telle qu'elle est caractérisée dans la revendication 9 permettra de réaliser un transistor à tension d'avalanche commandée magnétiquement variable perfectionné qui est sensible à des champs magnétiques.

L'objet de la présente invention permettra encore de réaliser un détecteur magnétique à faible bruit, à haute sensibilité, perfectionné qui utilise une structure de transistor à tension d'avalanche variable.

Description des figures
On décrira maintenant l'invention de manière détaillée en se référant à des modes de réalisation spécifiques qui seront mieux compris en se référant aux exemples illustratifs décrits et représentés sur les dessins dans lesquels:

La figure 1 représente les caractéristiques typiques tension/courant de drain d'extrêmes connus dans les mécanismes de claquage par avalanche qui illustrent le comportement de claquage par avalanche habituel différent de celui de la présente invention.

La figure 2 représente les caractéristiques tension/courant de drain pour le nouveau phénomène de claquage par avalanche crée, utilisé et commandé conformément à la présente invention.

La figure 3 représente sous forme schématique une vue en pseudo-plan d'un transistor à deux drains magnétiquement sensible utilisant le phénomène de claquage par avalanche qui constitue un élément de la présente invention.

Les figures 4A et 4B représentent les effets d'un champ de flux magnétique intersectant le dispositif de la figure 3 dans une direction perpendiculaire au plan du dispositif, ce champ ayant respectivement une première orientation et l'orientation opposée. Ces effets sont représentés par rapport à la caractéristique tension/courant de drain (collecteur) du mode de claquage par avalanche représenté sur la figure 2.

La figure 5 représente sous une forme schématique le modèle théorique qui décrit le fonctionnement du dispositif représenté sur la figure 3 ainsi que le procédé utilisable pour obtenir un signal de sortie électrique.

La figure 6 représente sous forme d'un schéma électrique le mode préféré d'utilisation des dispositifs de la présente invention dans un circuit électrique fonctionnant à des tensions appropriées pour leur intégration sur des micro-plaquettes de semi-conducteur à densité d'integration élevée ou à des niveaux compatibles avec de telles micro-plaquettes.

Les figures 7A et 7B représentent, respectivement, une vue en pseudo-plan et une vue en coupe verticale longitudinale d'une structure de transistor à deux drains magnétiquement sensible selon l'invention.

La figure 8 représente d'une manière plus détaillée certains des éléments de la nouvelle catégorie de transistors décrits et utilisés dans la présente invention sous forme d'un autre mode de réalisation d'un tel transistor.

Les figures 9A à 9F représentent schématiquement les effets produits dans la région située au voisinage immédiat des deux drains du transistor magnétiquement sensible. Ces effets sont décrits en rapport avec la présente invention en se référant à ce qui se produit lorsque la tension appliqué aux drains est accrue pour appauvrir la zone située entre les drains.

La figure 10 montre sous une forme schématique simplifiée la manière suivant laquelle l'impédance d'ionisation de drain à drain est déterminée pour un dispositif tel que celui représenté sue la figure 7A.

La figure 11 représente une courbe caractéristique tension de drain/courant de drain typique pour un transistor à deux drains magnétiquement sensible utilisé en tant que l'un des modes de réalisation de la présente invention et elle représente également la composante dite composante de bruit qui apparaît aux sorties de ce transistor.

Les figures 12A à 12C représentent schématiquement des vues en coupe verticale de divers autres modes de réalisation des dispositifs du type transistor utilisés dans la présente invention.

La figure 13A représente schématiquement un autre procédé utilisable pour créer le potentiel critique substrat-source nécessaire pour le fonctionnement de la présente invention.

La figure 13B est une vue à plus grande échelle d'un mode de réalisation préféré d'un dispositif magnétiquement sensible selon l'invention.

Les figures 14A à 14C représentent d'autres connexions de circuit préférées alternatives utilisables pour faire fonctionner les dispositifs de la présente invention.

Les figures 15A et 15B représentent, respectivement, une vue en coupe verticale d'un transistor du type préféré de la présente invention et une vue en plan de ce transistor, tel qu'incorporé à un dispositif spécifiquement conçu pour créer un claquage à tension d'avalanche commandée.

La figure 16 représente les caractéristiques tension/courant de drain pour un dispositif tel que celui décrit en se référant aux figures 15A et 15B et montre diverses tensions de claquage alternatives qui peuvent être obtenues pour divers paramètres physiques de la manière décrite.

La figure 17 représente un mode de réalisation préféré de l'invention, similaire à celui de la figure 12A dont il diffère par le fait qu'un canal de réduction du bruit est prévu à la surface du substrat et s'étend entre le drain et la source.

La figure 18 représente un autre mode de réalisation préféré alternatif d'un transistor à tension d'avalanche magnétiquement variable selon l'invention.

La figure 19 représente un graphique sur lequel on a tracé la courbe de la résistance de la région d'extension de la source par rapport à la résistance du substrat pour les performances optimales d'un dispositif tel que décrit en se référant à la figure 18.

Exposé de l'invention

Comme il apparaîtra ci-après, on a décrit ici une nouvelle catégorie de transistors à tension de claquage par avalanche susceptibles d'être utilisées soit comme transistors limiteurs de tension soit comme transistors magnétiquement sensibles. On décrira tout d'abord les caractéristiques connues et les paramètres critiques pour créer une nouvelle tension d'avalanche commandée qui n'avait pas été encore découverte dans un dispositif à conduction du type transistor au moyen d'effets physiques qui n'avaient pas été précédemment décrits. La théorie du fonctionnement d'un tel dispositif telle qu'elle est actuellement connue sera également décrite. En second lieu, on décrira des modes de réalisation préférés d'une structure de transistors à tension d'avalanche magnétiquement sensible utilisée comme détecteur magnétique selon la présente invention.

Un nouveau transistor présentant une transition brusque à l'état d'ionisation et de conduction qui est également un détecteur de champ magnétique extrêmement sensible a été découvert. Les preuves expérimentales indiquent que les mécanismes agissants pour les dispositifs et détecteurs de la catégorie décrite sont nouveaux et originaux et qu'ils n'avaient pas été découverts jusqu'ici. On estime qu'un effet entièrement nouveau intervient dans les présents détecteurs, effet qui ne peut pas être caractérisé par référence aux dispositifs détecteurs magnéto-résistifs ou à effet Hall de la technique antérieure. On montre que la caractéristique alpha de transistors bipolaires hybrides, en combinaison avec le facteur de multiplication de l'ionisation par impact, peut être adaptée de façon à créer une tension de claquage par avalanche commandée ayant la caractéristique nouvelle et originale d'être magnétiquement variable. La théorie du fonctionnement ne peut pas être expliquée par l'effet Hall ou par l'un des diverse mécanismes magnéto-résistifs déjà connus.

*Caractéristiques de base du transistor*

Les mécanismes actifs et les caractéristiques agissantes de base de nouveau transistor à tension d'avalanche commandée par l'effet alpha de la présente invention seront décrits ci-après. Des considérations techniques plus détaillées seront approfondies dans des chapitres suivants.

Le dispositif formant transistor et détecteur magnétique à tension d'avalanche commandée par l'effet alpha magnétiquement variable est réalisé de la manière la plus appropriée sous la forme d'un transistor bipolaire latéral à effet de champ NPN ou PNP hybride spécifique. A la différence des transistors de la technique antérieure, le nouveau dispositif fonctionne dans un mode de claquage par avalanche spécialement commandé. Dans le sens où elle est utilisée ici, l'expression "claquage par avalanche" est une expression générale pour décrire le processus appelé ionisation par impact. Le processus d'ionisation qui présente de l'intérêt se produit dans la matière semi-conductrice dans la région stochastique formée à la jonction P—N drain (collecteur)-substrat. A la différence des mécanismes d'avalanche de la technique antérieure, cependant, le nouveau mécanisme d'avalanche peut être spécifiquement commandé.

L'ionisation par impact peut être caractérisée d'une manière générale comme étant un phénomène qui se produit lorsque les porteurs minoritaires contenus dans la région d'appauvrissement du drain d'un transistor acquièrent suffisamment d'énergie cinétique dans une région à densité d'énergie de champ suffisamment élevée pour rompre les liaisons covalentes et créer une ionisation de la structure cristalline atomique de la matière semi-conductrice dans cette région. Ceci a pour effet la production de paires électron-trou, comme il est bien connu dans la technique.

Le processus de production de paires électron-trou désiré dans le cadre de la présente invention se produit lorsque la densité d'énergie du champ électrique à la jonction PN du drain est suffisamment élevée pour permettre aux porteurs minoritaires qui entrent dans la région à énergie élevée de créer des ruptures des liaisons covalentes. Le résultat de ce processus est une avalanche de paires électron-trou engendrées par un processus de multiplication. Ceci ne doit pas être confondu avec le claquage par avalanche de l'effet Zener. Ce dernier processus ne dépend pas des porteurs minoritaires pour le déclenchement du processus d'ionisation. Il y a lieu de noter à ce stade que les porteurs minoritaires peuvent être soit des électrons soit des trous mais que, dans les modes de réalisation spécifiques décrits ici, les porteurs minoritaires sont des électrons. Comme il est bien connu dans la technique, les termes porteurs "minoritaires" et "majoritaires" se réfèrent à des électrons et à des trous et au mode principal de conduction tel que défini pour le type de matière utilisé. Les porteurs "majoritaires" de la matière de type "P" sont des trous tandis que les porteurs "minoritaires" sont des électrons. L'inverse est valable pour les matières du type N.

Description des modes de réalisation

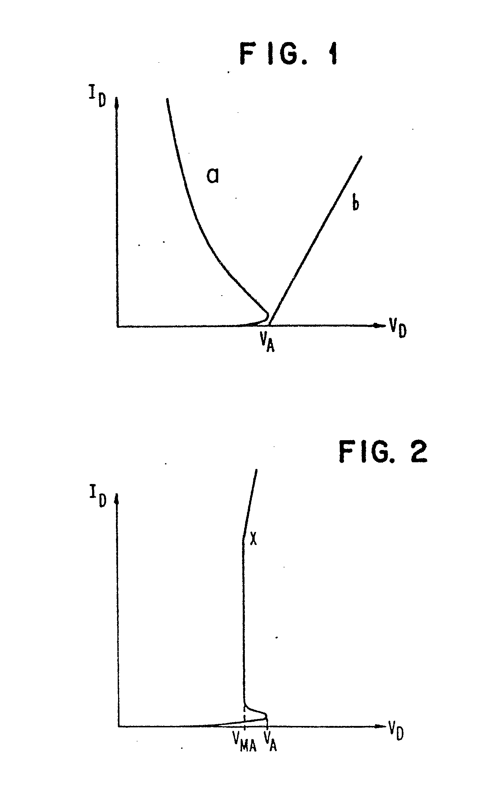

Sur la figure 1 à laquelle on se référera maintenant, on a représenté les courbes tension/courant caractéristiques pour le drain (collecteur) d'un transistor. Si le transistor employé est un transistor à effet de champ, la tension de porte est supposée nulle sur le graphique de la figure 1. Sur la figure 1, le courant de drain $I_D$ est indiqué en ordonnée tandis que la tension de drain $V_D$ est indiquée en abscisse. Une tension de claquage par avalanche spécifique $V_A$ à laquelle le dispositif est brusquement conducteur a été indiquée. On sait qu'il existe deux types de caractéristiques de conduction brusque par claquage par avalanche, comme représenté sur la figure 1. Le premier type représenté par la relation désignée par la lettre "a" minuscule est celui qui est présenté par la plupart des transistors à effet de champ et des dispositifs bipolaires classiques. Cette relation suit une courbe caractéristique à résistance négative qui est considérée, d'une manière générale, dans la technique comme étant celle du type claquage par avalanche. Un tel claquage par avalanche doit, en règle générale, être évité étant donné que cette condition d'impédance négative conduit à des surcharges de courant indésirable et à des oscillations et autres instabilités et non linéarités qui sont, en général, indésirables dans les transistors à effet de champ et dans les dispositifs bipolaires. La seconde caractéristique de claquage par avalanche, désignée par la référence b sur la figure 1, indique une caractéristique à résistance positive qui n'est pas aussi courante dans les transistors mais qui est caractéristique des diodes. Ce processus de claquage se produit généralement de la manière décrite ci-dessous.

Il doit être bien compris que sans injection par la source de porteurs minoritaires dans le semi-conducteur, une caractéristique de courant de drain à pente positive (courbe b figure 1) est une conséquence naturelle de la recombinaison des trous conduits par le substrat avec des porteurs minoritaires à l'intérieur de la région de type P située à l'extérieur de la région d'appauvrissement dans laquelle ils sont créés. En l'absence d'électrons (porteurs minoritaires) injectés par la source, les trous sont totalement conduits par un contact du substrat. La pente de cette région d'impédance positive de l'avalanche, représentée par la courbe b de la figure 1, s'est avérée dépendre de manière inverse de la caractéristique de concentration en accepteurs, $N_A$ de la région de type P. Pour injecter des électrons et éviter la conduction des trous par le substrat, la région de source doit être constituée par une matière du type opposé à celui du substrat. Dans le mode de réalisation préféré, on laisse la tension du substrat flotter au-dessus du potentiel de la source.

Le fonctionnement des dispositifs de la présente invention dépend de la création d'une condition de tension de claquage par avalanche commandée rendant le dispositif brusquement conducteur, telle que représentée sur la figure 2.

Sur la figure 2, le courant de drain ($I_D$) a été à nouveau indiqué en ordonnée et la tension de drain en abscisse. Une nouvelle tension de claquage spécifique, $V_{MA}$, ayant une caractéristique verticale ou approximativement verticale à la suite d'une caractéristique initiale légèrement négative a été représentée. La nouvelle tension de claquage critique $V_{MA}$ est également la tension d'avalanche commandée, à effet alpha magnétiquement variable, utilisée dans les transistors et dans les détecteurs magnétiques selon l'invention. On notera que cette nouvelle tension de claquage par avalanche existe à une plus basse tension que la tension de claquage par avalanche typique $V_A$ représentée sur la figure 1.

La nouvelle caractéristique courant/tension représentée sur la figure 2 présente un très faible profil d'impédance (essentiellement une impédance de drain nulle) qui existe sur une partie importante de l'intervalle de courant et qui se produit principalement à une tension d'avalanche critique $V_{MA}$. Dans certaines circonstances qui seront décrites ci-dessous, la tension critique $V_{MA}$ peut être modulée ou changée au moyen d'un champ magnétique et la tension $V_{MA}$ peut être déplacée vers la gauche ou vers la droite de la figure 2.

La tension critique de claquage représentée sur la figure 2 peut être créée et commandée par un choix correct des caractéristiques et de la géométrie des éléments du dispositif et par une commande correcte du facteur de multiplication de l'ionisation en combinaison avec un facteur de probabilité alpha qui sera décrit ultérieurement. Ces facteurs ainsi que d'autres qui déterminent la tension de claquage critique sont les suivants:

La condition préférée d'avalanche à impédance nulle est obtenue:

   a. en créant une région appauvrie à l'intérieur de la matière semi-conductrice qui s'étend au moins sur une partie de la distance du drain à la source;

   b. en créant une région de diffusion de source (émetteur) à l'intérieur du substrat en une matière du type opposé à celui du substrat;

   c. en commandant le rendement d'injection de la source. Ceci commande d'une manière correspondante une partie de la grandeur globale du facteur de probabilité de recombinaison électron-trou $\alpha$. Cette technique de commande est représentée et décrite ci-après et est liée aux durées de vie des porteurs minoritaires et des porteurs majoritaires ou taux de recombinaison qui est un phénomène lié au rendement de transport;

   d. en commandant la résistivité de la région d'extension de la source ou région d'injection commandée qui fonctionne en émetteur de porteurs minoritaires. La région d'extension de la source s'est avérée commander le rendement d'injection comme décrit ci-après. Pour obtenir les meilleures performances, le produit du courant de drain par la résistance équivalente de la région d'injection commandée ou région d'extension de la source doit être proche du potentiel du contact de la source

$$\psi = \frac{KT}{q} \ Ln \ \left( \frac{N_A \, N_{DE}}{N_i^2} \right)$$

équation dans laquelle:

$N_A$ est la concentration en accepteurs du substrat;

$N_{DE}$ est la concentration en donneurs de la région d'extension de la source qui est l'émetteur;

$N_i$ est la concentration en porteurs intrinsèque de la matière de substrat;

K est la constante de Boltzman;

T est la température en degrés Kelvin;

q est la charge électronique élémentaire.

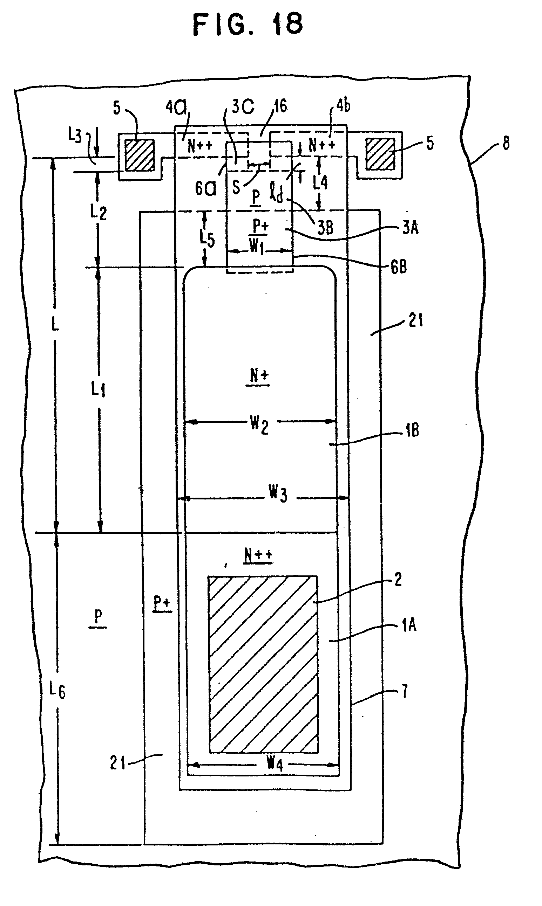

   e. en commandant la distance $L_2$ (Fig. 18) qui sépare la jonction émissive, au niveau de la région d'injection commandée, de la zone appauvrie au voisinage des régions de drain. Il a été démontré que la recombinaison des électrons (rendement du transport) à l'intérieur de cette région comprise à l'intérieur de la distance $L_2$ est proportionnelle à la longueur de cette région et à la concentration en accepteurs de cette région, qui peut également être modifié en tant que moyen de commande de la valeur $P_2$; voir eg. (30).

   f. en choisissant la résistivité du substrat. On trouve que le facteur de rendement de transport $\alpha_T$ et le rendement d'injection $\gamma$ sont tous deux proportionnels à la résistivité du substrat.

A la différence de la plupart des transistors, le présent dispositif fonctionne dans un mode de claquage par avalanche spécial. Comme déjà noté, l'expression "claquage par avalanche" est une expression générale qui décrit les effets d'un processus appelé ionisation par impact. Le processus est commandé de façon à se produire au voisinage de la région stochastique formée à la jonction PN du drain (collecteur). A la différence de la plupart des mécanismes d'avalanche, le mécanisme d'avalanche de ces dispositifs est un procédé d'ionisation commandé. En général, comme précédemment indiqué, l'ionisation par impact est un mécanisme qui se produit lorsque les porteurs minoritaires contenus à l'intérieur de la région d'appauvrissement du drain acquièrent une énergie cinétique suffisante pour rompre les liaisons cristallines covalentes, provoquant ainsi la génération de paires électron-trou. Le processus désiré de génération de paires électron-trou se produit si la densité d'énergie du champ électrique (1/2 E.D) à la jonction PN du drain est suffisamment élevée pour permettre aux porteurs minoritaires (électrons) entrant dans la région à densité d'énergie élevée de créer les ruptures des liaisons covalentes. A nouveau, ce processus d'avalanche ne doit pas être confondu avec le claquage par effet Zener. Ce dernier processus ne dépend pas des porteurs minoritaires pour déclencher le processus d'ionisation. Les caractéristiques courant/tension de drain qui réflètent les mécanismes de claquage par avalanche classiques des transistors à effet de champ habituels ont été représentés sur la figure 1 décrite ci-dessus.

La plupart des dispositifs bipolaires et des transistors à effet de champ présentent une courbe caractéristique (a) à résistance négative qui est plus caractéristique des claquages par avalanche que la caractéristique à résistance positive représentée par la courbe (b). Le fonctionnement du nouveau dispositif dépend d'une condition d'avalanche critique représentée sur la figure 2. Comme noté ci-dessus, cette nouvelle caractéristique présente une impédance de drain essentiellement nulle à l'intérieur d'un intervalle de courant important et elle se produit à une tension d'avalanche critique $V_{MA}$. Cette tension critique est inférieure à la tension habituellement définie comme la tension de claquage par avalanche $V_A$ représentée sur la figure 1. La tension critique $V_{MA}$ peut être modulée au moyen d'un champ magnétique et sera appelée la tension d'avalanche magnétique, TAM.

Les propriétés critiques peuvent être commandées en choisissant correctement la géométrie du dispositif et en commandant la valeur $M°\alpha$ de la manière indiquée dans l'équation (1). Dans l'équation (1), le produit du facteur de multiplication du courant d'avalanche, M, par le facteur de probabilité de recombinaison des paires électron-trou $\alpha$ défini par l'équation (2) est donné:

$$M°\alpha = 1 - (\frac{V_{MA}}{V_{CB_O}})^N \qquad (1)$$

dans laquelle:

$V_{MA}$ est la tension d'avalanche magnétique;
$V_{CB_O}$ est la tension de claquage par avalanche drain-substrat avec la source en circuit ouvert et le contact du substrat à la tension de la terre;
N est l'exposant de multiplication de l'avalanche.

$$\alpha = \gamma\alpha_T \qquad (2)$$

dans laquelle:

$\gamma$ est le rendement d'injection;
$\alpha_T$ est un facteur de rendement du transport.

Les facteurs ci-dessus sont commandés collectivement pour obtenir une valeur critique

du produit $M°\alpha$ sur la totalité d'un intervalle de courant de drain (collecteur) important. Expérimentalement, on a trouvé que le produit $M°\alpha$ devait, de préférence, être proche de 0,5 mais inférieur à 1.

Pour résumer les conclusions, lorsque le produit $M°\alpha$ correct est obtenu, la condition d'avalanche critique de la figure 2 est obtenue. Si, cependant, le produit du facteur de probabilité $\alpha$ par le facteur de multiplication d'avalanche M s'approche de l'unité et est une fonction non linéaire du courant, on obtient une caractéristique du courant de drain à résistance négative, telle que celle représentée par la courbe (a) de la figure 1. Si aucune injection par la source de porteurs minoritaires n'est effectuée et si un contact du substrat est raccordé à la terre, on obtient alors la courbe caractéristique de courant de drain à pente positive désignée par la référence (b) sur la figure 1.

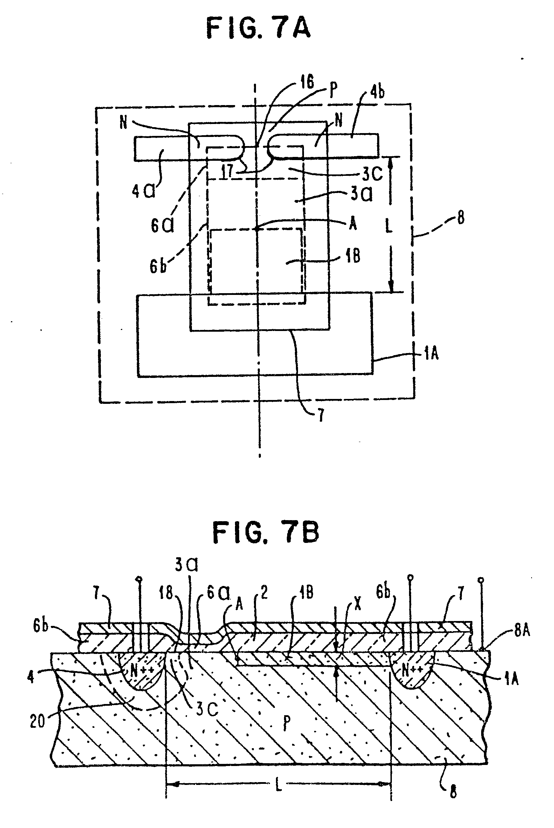

Un paramètre supplémentaire critique pour les performances de ces dispositifs concerne les moyens favorisant l'ionisation ou activeur d'ionisation. Le rendement ou la sensibilité magnétique de ces dispositifs dépend de la création d'une activité d'ionisation par impact localisée. Il est désirable que l'ionisation par impact ne se produise que dans la région de drain sous-tendue par la région de recombinaison des porteurs majoritaires et des porteurs minoritaires. Comme représenté sur la figure B, les moyens favorisant l'ionisation peuvent être constitués par la région a formant une fenêtre revêtue d'une mince couche d'oxyde intercalée entre l'électrode d'accélération 7 et la surface du canal semi-conducteur 18. Le champ électrique engendré entre l'électrode d'accélération 7, normalement mise à la terre, et les régions de drain 4 accroît le champ dans la région d'appauvrissement du drain 20. Ces deux composantes de champ sont suffisantes pour accroître la densité d'énergie du champ électrique à l'intérieur de la région appropriée pour favoriser l'ionisation par impact localisée. L'emplacement désiré pour l'ionisation est la région qui entoure les extrémités 17 des drains sur la figure 7A et fait face à la région émettrice 1B.

L'équation (3) donne une expression approximative pour définir la tension de claquage de seuil d'avalanche $V_{CB_O}$, $V_{CB_O}$ étant la tension de claquage collecteur-substrat avec l'émetteur en circuit ouvert.

$$V_{CB_O} = \frac{1}{2}\varepsilon_I^2 [\frac{1}{(\frac{q}{\varepsilon_s})N_A + \frac{\varepsilon_I}{25T_{ox}}}] \qquad (3)$$

avec $N_D \gg N_A$

dans laquelle:
$\varepsilon_I$ est l'intensité du champ d'ionisation;
$N_A$ est la concentration en accepteurs;

$N_D$ est la concentration en donneurs des diffusions de drain;

$T_{ox}$ est l'épaisseur de la couche d'oxyde;

$\varepsilon_s$ est la constante diélectrique du silicium.

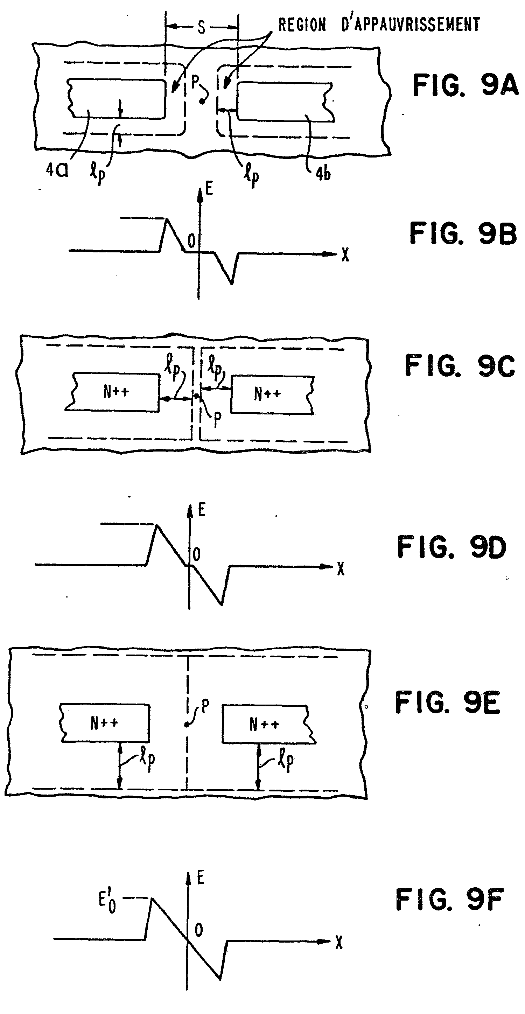

Dans le mode de réalisation de la figure 8 à laquelle on se référera, d'autres moyens pour favoriser l'ionisation locale sont réalisés en implantant une couche de bore de type P[+] 19 au-dessous de la surface du substrat semi-conducteur 8. La concentration en accepteurs de porteurs minoritaires de la couche P[+] doit être supérieure à la concentration en accepteurs de la matière semi-conductrice de type P environnante. Une couche d'appauvrissement 20 qui s'étend à partir des drains vers la source est formée à la jonction de la couche 19 favorisant l'ionisation et des diffusions de drain 4. La valeur de la tension de claquage par avalanche $V_{CB_0}$ pour le dispositif de la figure 8 est donnée d'une manière approximative par l'équation (4).

$$V_{CB_0} = \frac{1}{2} \, \varepsilon_{IC} \, {}^2 \frac{\varepsilon_s}{gN_{AI}} \qquad (4)$$

dans laquelle:

$\varepsilon_{IC}$ est l'intensité critique du champ d'ionisation pour une concentration en accepteurs implantés donée, $N_{AI}$.

$N_{AI}$ est la concentration en accepteurs du canal favorisant l'ionisation implantée.

L'électrode 7 sert essentiellent d'écran pour empécher les champs électromagnétiques parasites de porter atteinte aux performances du dispositif. La couche d'oxyde 6b est relativement épaisse, et a une épaisseur de l'ordre 400 nm de (4000 Å) ou davantage et elle a peu d'effet sur la détermination de la tension de claquage. Par contraste, une couche d'oxyde relativement mince 6a (Figure 7B) aurait une épaisseur d'approximativement 30 nm (300 Å).

La création des caractéristiques ci-dessus de tension critique de claquage par avalanche, la géométrie du dispositif et les paramètres critiques ainsi que le mode de construction et les applications seront décrits avec plus de détails ci-dessous. Cependant, il est désirable, à ce stade, de décrire de manière plus détaillée les nouveaux effets magnétiques originaux attribués aux modulations de la tension de claquage critique au moyen de champs magnétiques pour des dispositifs réalisés sous la forme de détecteurs magnétiques.

*Détecteur magnétique*

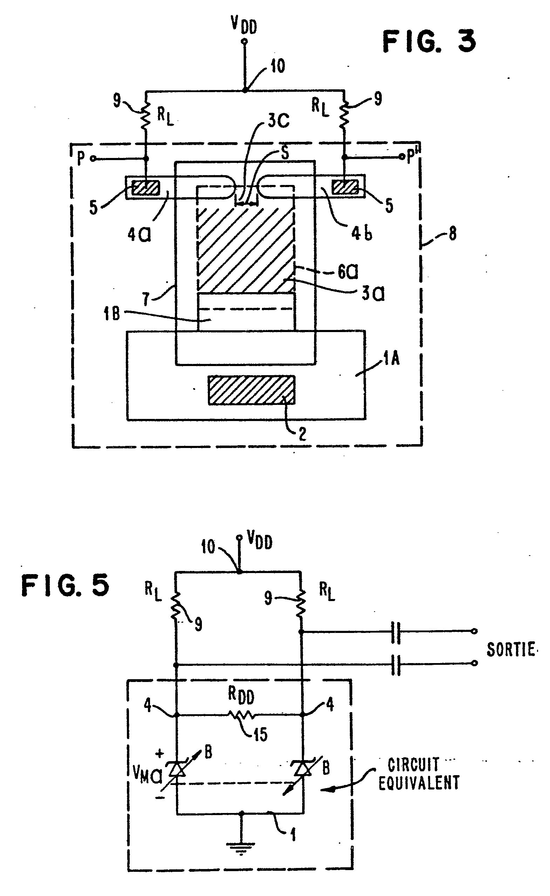

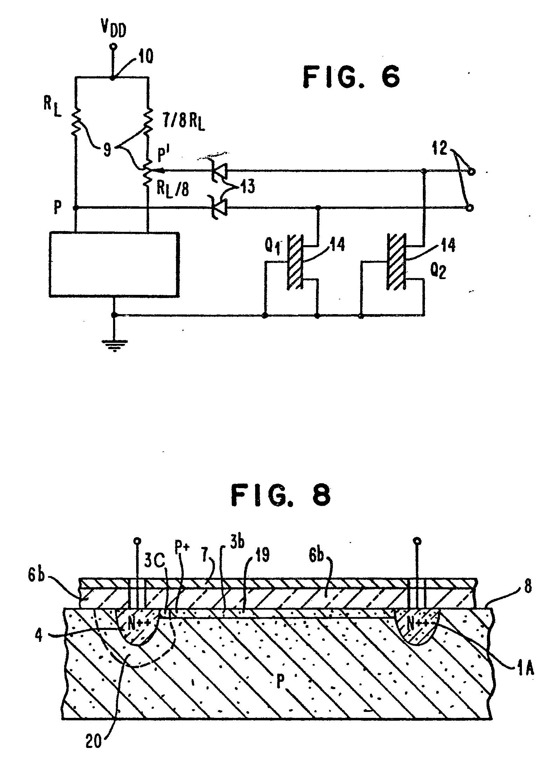

Un effet magnétique nouveau et jusqu'ici encore inconnu est utilisé d'une manière plus particulièrement avantageuse lorsqu'un dispositif à double drain (collecteur) est construit en utilisant le transistor à tension d'avalanche commandé par l'effet alpha de la présente invention. Un tel dispositif a été schématiquement représenté dans la vue en pseudo-plan de la figure 3 dans laquelle, pour plus de clarté, les couches d'oxyde et de métal, recouvrant le dispositif, ont simplement été indiquées par des lignes sans tenir compte du fait que ces lignes puissent être cachées au-dessous des couches.

On décrira tout d'abord en termes simples les caractéristiques de fonctionnement de base du transistor magnétiquement sensible. Des considérations techniques plus détaillées seront développées dans les paragraphes qui suivront.

Sur la figure 3, une source de porteurs minoritaires pour une matière de type P (électrons) a été désignée par la référence 1A. La source 1A est alimentée en électrons par un contact métallique 2 normalement raccordé à une terre électrique (non représentée). Les électrons de la source 1A sont conduits dans une région de canal 3 en direction des drains 4 (collecteurs) qui sont espacés l'un de l'autre d'une petite distance S, comme représenté. Les drains 4 sont munis de contacts métalliques 5 destinés à être connectés aux points de sortie P et P' en série avec des résistances de charge 9 qui sont connectées en commun à une source de tension de drain $V_{DD}$ désignée par la référence 10. Un substrat en une matière semi-conductrice ou autre support pour les éléments semi-conducteurs a été désigné par la référence 8.

Les figures 7A et 7B sont respectivement une vue de dessus et une vue en coupe verticale d'un transistor NPN magnétiquement sensible caractéristique. La configuration NPN a été choisie aux fins de l'illustration du fait que les dispositifs logiques à tension positive sont plus couramment utilisés. La description qui suit s'applique également aux configurations de dispositifs PNP en changeant de la manière approprié les types des matières.

On a représenté une région semi-conductrice de type P 8 dans laquelle sont formées aux moins deux régions de drain (collecteur) 4 espacées l'une de l'autre. Ces régions sont des régions N[++] fortement dopées. Une région de source N[++] fortement dopée, 1A, a été également représentée comme ayant été diffusée ou implantée dans la région P et espacée de la région des drains (collecteurs) d'une distance critique L. La région de source 1A est positionnée de telle sorte qu'elle est coupée en son milieu par une ligne partant du centre de la région de la fente 16 séparant les régions de drain 4.

Une région d'injection commandée ou région d'extension de la source, qui fonctionne en émetteur, a été désignée par la référence 1B. Cette région commande en partie la recombinaison des porteurs majoritaires (trous) avec les porteurs minoritaires (électrons) injectés par la source par la commande du rendement d'injection de l'émetteur 1B. Les porteurs majoritaires sont créés par ionisation par impact. Cette région de canal est représentée comme occupant une partie de la distance entre la source et les drains. La région 1B d'extension de la source est composée d'ions donneurs de porteurs minoritaires, tels que des ions phosphore implantés à une profondeur X au-dessous de la surface du substrat 8. La concentration en ions implantés constitue un moyen pour commander le rendement d'injection et elle influence le mécanisme de recombinaison des porteurs minoritaires (électrons) et des porteurs majoritaires (trous) engendrés par le mécanisme d'ionisation par impact. En effet, la nature de la région d'extension de la source 1B a des effets extrêmement nets et importants sur la probabilité de recombinaison électron-trou ou facteur $\alpha$ qui existe entre les drains (collecteurs) et la source (émetteur). Cette région d'extension de la source est un moyen critique de commande du facteur $\alpha$ pour le dispositif et elle constitue l'un des moyens grâce auxquels la condition d'avalanche critique représentée sur la figure 2 peut être obtenue.

Comme les spécialistes de la technique le comprendront, la totalité de la structure décrite ci-dessus (y compris les résistances de charge 9 si désiré) peut ête formée sur un substrat semi-conducteur en utilisant les techniques de construction des dispositifs à degrés d'intégration élevé employées pour la fabrication des transistors et autres dispositifs à semi-conducteur. La région du substrat 8 a été indiquée par un cadre en traits interrompus sur la figure 3. De nouveaux éléments constitués par une mince région d'oxyde 6a (représentée par deslignes en traits interrompus sur la figure 3) et par une électrode métallique 7 qui recouvrent dans l'ensemble la zone de canal 3 sont utilisés pour créer la structure. La mince région d'oxyde 6a est simplement une zone de l'oxyde isolant utilisée d'une manière générale (dans la technologie du silicium) qui recouvre la surface du substrat 8 et est utilisée à des fins qui seront décrites ci-après. Une électrode accélératrice pour les porteurs minoritaires a été représentée par la région de recouvrement 7. L'électrode accélératrice peut être constituée par un élément conducteur métallique qui recouvre la mince région d'oxyde 6a et s'étend au-dessus de parties de la source 1A, 1B et des drains 4, comme représenté sur la figure 3.

Le nouvel effet magnétique décrit et utilisé dans la présente invention se produit chaque fois qu'un champ magnétique perpendiculaire au plan de la surface du substrat semi-conducteur intersecte le dispositif. Ceci crée un changement de la tension d'avalanche commandée existant dans le dispositif lorsqu'il fonctionne dans une condition de tension d'avalanche. Par exemple, en appliquant un champ magnétique "nord" à la surface du substrat, la tension d'avalanche apparaissant au drain 4b est abaissée et celle qui apparaît au drain 4a est simultanément élevée d'une même quantité. Ainsi, il existe un changement de différence de potentiel entre les deux bornes de sortie P et P' dont la grandeur est le double du changement de tension à chaque drain. La polarité du décalage induit dans la tension d'avalanche dépend de la polarité du champ magnétique appliqué dans la direction perpendiculaire à la surface du substrat semi-conducteur. La région ayant la plus grande sensibilité est celle qui se trouve dans la région appauvrie située au voisinage immédiat de la fente S qui sépare les deux régions de drain 4a et 4b.

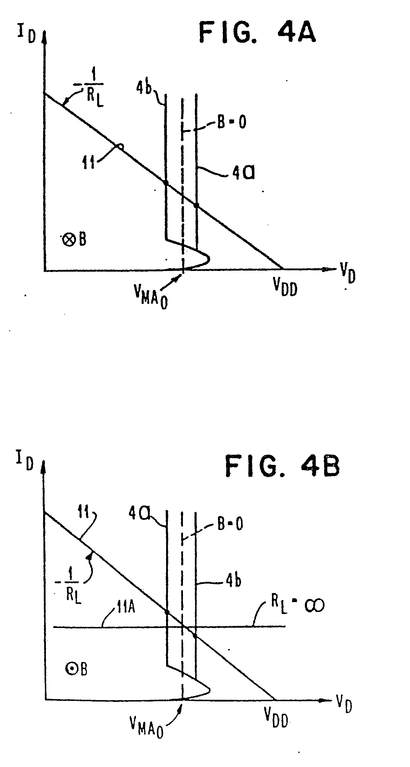

Les effets de cette tension d'avalance commandée par l'effet $\alpha$ magnétiquement modulée ont été représentés sur les figures 4A et 4B. Le détecteur magnétique représenté sur la figure 3 est utilisé avec des résistances de charge de drain séparées 9 (RL), comme représenté sur la figure 3. Une tension positive est appliquée à la borne 10 d'alimentation en tension des drains et la source 1A est normalement raccordée par l'intermédiaire du contact 2 à la tension de la terre. Lorsqu'une différence de tension suffisante entre la source et les drains a été atteinte, la tension d'avalanche commandée $V_{MA}$ peut être modulée par un champ de flux magnétique intersectant le substrat semi-conducteur.

Sur les figures 4a et 4B, les effets des résistances de charge 9 ont été superposés en tant que lignes de charge aux courbes tension/courant de drain d'une manière bien connue dans la technique. Ces lignes sont les lignes de charge 11. Comme représenté sur la figure 4A, lorsqu'un champ magnétique nord (entrant perpendiculairement dans le plan du dession) intersecte le dispositif, la tension du drain 4a se décale vers le haut (vers la droite en considérant la figure 4A) et celle du drain 4b se décale vers le bas (vers la gauche) à partir du point auquel la tension d'avalanche commandé initiale $V_{MA_0}$ existait lorsqu'aucun champ magnétique n'était présent. La tension de claquage initiale $V_{MA_0}$ a été représentée sur les figures 4A et 4B par la ligne en traits interrompus désignée B=0 pour indiquer la condition de champ de flux magnétique nul.

Le signal de réponse au champ magnétique peut être mesuré sous la forme de la différence de tension obtenue entre les bornes P et P' de la figure 3. La situation est représentée par la ligne de charge donnée 11 dans chacune des figures 4A et 4B sur laquelle le déplacement par rapport à la tension d'avalanche initiale $V_{MA_0}$ (telle que représentée par la tension de sortie du drain 4a ou du drain 4b) est mesurée différentiellement. Ce dispositif peut être rendu très sensible à des champs magnétiques. Une sensibilité supérieure à 10 mV par gauss a été obtenue déjà dans des expériences de laboratoire. Ceci correspond à une sensibilité qui, selon une estimation prudente, est égale à au moins 500 fois celle des meilleures cellules à effet Hall connues. La théorie actuelle prédit que des sensibilités bien plus élevées seront obtenues. A la différence d'autres détecteurs magnétiques, le présent dispositif est très petit, c'est-à-dire qu'il a une superficie inférieure à 1 × 10⁻⁶ cm². Un rapport signal/bruit très élevé pour une bande passante donnée est également le résultat de cette technologie. Un rapport signal/bruit supérieur à trois par gauss mégahertz est typique pour un dispositif de ce type. Les dispositifs choisis pour déterminer le rapport signal/bruit utilisent une largeur de bande de base de 1 mégahertz aus fins de normalisation.

De nombreuses applications du détecteur magnétique n'exigent pas la capacité de détecter des composantes de champ de flux magnétique permanentes ou invariables. Bien que le transistor magnétiquement sensible de la présente invention soit parfaitement capable de détecter des composantes de champ de flux permanentes de l'une ou l'autre polarité, les applications habituelles des détecteurs magnétiques ne requièrent habituellement que la capacité de détecter un niveau de champ de flux alternatif. Les applications de tels détecteurs sont notamment celles relatives à des analyseurs de rubans magnétiques, de bandes et de disques magnétiques, etc. et d'autres indices codés de type magnétique. Dans de telles circonstances, les bornes de sortie des drains, P et P', représentées sur la figure 3 peuvent être raccordées au moyen d'un couplage capacitif à un circuit de démodulation et à des circuits logiques. Une telle configuration de couplage en régime alternatif a été représentée sur la figure 5.

On notera, en considérant les figures 4A et 4B, que les courbes courant-tension de sortie des drains 4a et 4b sont déplacées en directions opposées en réponse à une direction donnée de flux magnétique. Sur la figure 4A qui représente la situation qui existe lorsque le champ de flux entre dans le plan du dessin, la borne de sortie du drain 4a est à une tension supérieure à la tension de claquage par avalanche initiale $V_{MA_o}$ tandis que la borne de sortie du drain 4b est à une tension inférieure. La situation inverse existe dans le cas représenté sur la figure 4B. Sur la figure 4B, qui correspond au cas dans lequel le champ de flux magnétique a une polarité inverse de celle représentée sur la figure 4A, l'effet opposé est obtenu mais d'une manière symétrique, en ce sens que les déplacements par rapport à la tension d'avalanche initiale sont égaux mais sont de polarité opposée à ceux représentés sur la figure 4A.

De nombreuses applications peuvent nécessiter la détection de composantes de champ magnétique permanentes. Le présent dispositif a une si large réponse en bande de fréquence (qui s'étend à partir de zéro Hertz jusqu'à bien dans la région des mégahertz) qu'il présente des avantages qui lui sont propres pour de nombreuses applications différentes. Les limites de fréquence supérieures du dispositif n'ont pas encore été déterminées. Cependant, le couplage d'une composante différentielle du signal en courant continu aux bornes de sortie nécessite que deux problèmes soient résolus. En premier lieu, il peut être nécessaire d'équilibrer en courant continu la tension entre les bornes de sortie P et P' pour obtenir une symétrie autour d'un niveau de signal de sortie nul. En second lieu, il peut être nécessaire d'obtenir un décalage du niveau de la tension de sortie en courant continu qui soit compatible avec les niveaux de tension des circuits bipolaires, ou à effet de champ classiques, c'est-àdire typiquement de 5 à 12 V. La seconde condition mentionnée est une conséquence directe des tensions en courant continu relativement élevées (typiquement de l'ordre de 25V) qui sont utilisées pour créer la condition d'ionisation par impact nécessaire pour la génération de la tension d'avalanche commandée. Cette tension relativement élevée apparaît aux bornes de sortie P et P' de la figure 3.

La figure 6 représente un procédé utilisable pour combiner l'opération de décalage du niveau de tension continue avec un équilibrage de la tension de sortie.

Le décalage du niveau en courant continu est effectué en utilisant des transistors limiteurs de tension qui sont, en fait, des transistors à tension d'avalanche commandée par l'effet alpha de la présente invention utilisés d'une manière légèrement différente. Ces dispositifs seront naturellement complètement décrits ci-après mais on décrira sommairement leur utilisation à ce point.

Les transistors limiteurs de tension sont couplés entre les bornes P et P' des drains du détecteur magnétique et les bornes de sortie 12 représentées sur la figure 6. Les transistors limiteurs de tension sont désignés par la référence 13 et, bien que le symbole utilisé pour représenter les diodes de Zener ait été employé pour les représenter graphiquement, on comprendra que ces transistors ne sont pas des diodes de Zener (bien que de telles diodes puissent être utilisées à leur place) mais sont des transistors à tension d'avalanche commandée par l'effet alpha spécifiques décrits ici. Deux transistors à effet de champ à mode d'appauvrissement Q1 et Q2, désignés par les références 14 sur la figure 6, sont utilisés pour maintenir un faible courant de polarisation inverse nécessaire pour le fonctionnement correct des transistors limiteurs de tension 13. L'agencement d'équilibrage manuel qui comprend un potentiomètre ayant une résistance d'environ 1/8 $R_L$ est une partie de la résistance de charge de sortie 9 d'une des branches du circuit de sortie, comme représenté.

Un système d'équilibrage manuel plus classique, tel qu'un potentiomètre monté directement entre les bornes de sortie, ne fonctionne pas avec la présente invention du fait de la très faible impédance interne d'ionisation de drain à drain $R_{DD}$. Celi a été représenté sur la figure 5 sur laquelle un modèle schématique d'une sortie à couplage capacitif du détecteur magnétique du type décrit dans la présente invention a été représenté. La faible impédance interne $R_{DD}$ entre les drains 4 est d'une grande utilité comme on le décrira plus en détail ci-après.

Le schéma de circuit représenté sur la figure 6 peut être facilement construit en utilisant les concepts et techniques de fabrication des circuits intégrés ou, plus particulièrement, en utilisant la technologie dite du silicium sur saphir. Ce dernier type de technique est particulièrement intéressant étant donné que les régions semi-conductrices individuelles peuvent être facilement et totalement isolées les unes des autres, dans le sens électrique, en étant positionnées sur des parties isolées du substrat en saphir non conducteur. Cette technique est, naturellement, bien connue des spécialistes et à ce stade, on ne décrira pas cet aspect avec plus de détail.

Comme représenté sur la figure 5 à laquelle on se référera à nouveau, le modèle schématique du détecteur actif selon la présente invention peut être décrit d'une manière générale comme étant constitué par une paire de diodes à tension d'avalanche variable montées en parallèle et fonctionnant en sens inverse l'une de l'autre en réponse à l'intersection d'un vecteur B de flux magnétique.

*Conditions fondamentales auxquelles doit répondre le transistors à tension d'avalanche commandée par l'effet alpha*

Les conditions et paramètres fondamentaux nécessaires pour la construction et le fonctionnement des transistors à tension d'avalanche commandée par l'effet alpha de la présente invention sont résumés comme suit:

1) il est formé au moins une zone de drain (collecteur) dans une région de matière semi-conductrice, cette zone étant constituée par une matière d'un type opposé à celui de la région du substrat dans laquelle ou sur laquelle elle est formée;

2) il est formé au moins une zone de source (émetteur) dans ou sur le même substrat semi-conducteur, cette zone de source étant espacée de la zone de drain d'une distance uniforme et critique L. La matière de la source est du même type que celle du drain et est d'un type opposé à celui du substrat semi-conducteur dans ou sur lequel elle est formée;

3) des moyens de commande du rendement d'injection sont formés dans une région attenante à la source et s'étendent sur au moins une partie de la distance qui sépare la source du drain, ces moyens servant d'émetteur de porteurs minoritaires. La partie de commande du rendement d'injection de la source peut être constituée par une région à concentration de donneurs commandée qui s'étend dans la région située entre le drain et le contact de la source. La conductivité électrique de la région de commande du rendement d'injection agit pour commander le rendement d'injection $\gamma$.

4) des moyens favorisant l'ionisation par impact sont formés, ces moyens devant s'étendre sur au moins une partie de la distance L entre le drain et la source.

5) des moyens de commande du rendement du transport sont formés pour commander le taux de fourniture des porteurs minoritaires au voisinage de la région de drain où l'ionisation se produit.

6) une région conductrice intrinsèque ou de forte résistivité dans laquelle l'ionisation se produit et qui peut être ou est effectivement appauvrie est formée à l'intérieur du semi-conducteur dans une région qui s'étend sur au moins une partie de la distance entre le drain et la source. Cette région particulière occupe une zone de profondeur finie au-dessous de la surface du substrat semi-conducteur dans la région qui sépare le drain de la source. Cette région est conductrice et permet la combinaison des porteurs majoritaires créés par l'ionisation par impact avec les porteurs minoritaires injectés. Cette région peut être soit contiguë aux moyens favorisant la promotion de l'ionisation soit disposée au-dessous de ces moyens.

*Conditions que doit remplir le transistor magnétiquement sensible*

Les conditions critiques et les paramètres fondamentaux d'un transistor magnétiquement sensible utilisant la tension d'avalanche commandée par l'effet alpha sont les mêmes que celles de la structure de transistor de base et comprennent, en outre, l'utilisation d'autres éléments structuraux préférés qui sont les suivants:

1) il y a au moins deux drains du type décrit en se référant au transistor à tension d'avalanche commandée par l'effet alpha;

2) ces régions de drain sont espacées l'une de l'autre d'une distance S appelée ici "largeur de la fente";

3) les moyens favorisant l'ionisation par impact qui s'étendent sur au moins une partie de la distance entre les drains et la source occupent un espace au nivau des drains qui est disposé symétriquement par rapport au centre de la fente S qui sépare les zones de drain individuelles.

Aussi bien pour le transistor à tension d'avalanche commandée par l'effet alpha que pour le détecteur magnétique qui utilise d'une manière générale les mêmes éléments mais qui utilise au moins deux drains, etc., comme indiqué ci-dessus, une source de potentiel doit être raccordée aux bornes de la source et du drain ou des drains. La tension source-drain doit être suffisante pour déclencher la condition d'avalanche critique. La source peut être directement raccordée à une borne des moyens d'alimentation en tension et les drains à l'autre borne de ces moyens par l'intermédiaire de résistance limitant le courant.

Pour le fonctionnement du dispositif en détecteur magnétique, un champ magnétique est appliqué dans la direction perpendiculaire à la surface de la région de substrat semi-conducteur et a généralement l'effet maximum au proche voisinage de la fente S entre les régions de drain. Le signal de réponse au champ magnétique, constitué par une tension différentielle, peut être mesuré entre les bornes de sortie raccordées aux contacts 5 des drains, comme représenté sur la figure 3. Le circuit de la figure 5 ou celui de la figure 6 s'est avéré particulièrement avantageux à cette fin.

*Théorie détaillée*

On décrira maintenant de manière plus détaillée les éléments de base du transistor à tension d'avalanche commandée par l'effet alpha et du dispositif magnétiquement sensible utilisant de tels transistors, en se référant à la théorie du fonctionnement telle qu'elle est actuellement comprise, et en se référant aux modes de réalisation préférés spécifiques et aux procédés de construction employés.

Comme décrit brièvement précédemment, les figures 7A et 7B représentent respectivement une vue en plan et une vue en coupe verticale d'un dispositif NPN caractéristique du type utilisé ici. La configuration NPN a été choisie uniquement à des fins d'illustrations et du fait que, comme les dispositifs logiques à tension positive sont ceux qui sont les plus couramment utilisés, les signaux de sortie du dispositif NPN sont directement utilisables. La description s'applique naturellement également aux configurations de dispositif PNP, comme le comprendront les spécialistes de la technique. Dans le sens où elles sont utilisées ici, les désignations PNP, NPN, etc. se réfèrent au type des porteurs majoritaires de la matière et sont celles normalement utilisées dans la technique.

Les éléments de base du transistor magnétiquement sensible de la présente invention ont été représentés sur les figures 7A et 7B. Sur la figure 7B, on a représenté une région semi-conductrice de type P, 8, dans laquelle sont implantées ou diffusées au moins deux régions de drain (collecteur) 4 espacées l'une de l'autre. Ces régions sont en une matière relativement fortement dopée $N^{++}$. On a également représenté une région de source (émetteur) fortement dopée $N^{++}$, 1A, qui est diffusée ou implantée dans la région de type P 8 et est espacée des régions de drain 4 d'une distance critique L. La source 1A et sa région d'extension 1B sont positionnées d'une manière telle que la source 1A est coupée en son milieu par la ligne centrale de la région 16 de la fente séparant les régions de drain 4. Ceci a été plus particulièrement représenté sur la figure 7A sur laquelle cette ligne centrale bissectrice a été tracée.

Le canal conducteur 3 représenté sur les figures 7A et 7B est composé de plusieurs parties 3a, 3c. La partie 3a commande, en partie, la recombinaison des porteurs majoritaires (trous) avec les porteurs minoritaires (électrons) injectés par la source 1A. Les porteurs majoritaires sont créés dans la partie 3c dans laquelle la plus grande partie de la recombinaison se produit. Ces porteurs sont créés par le processus d'ionisation par impact qui crée des paires électron-trou comme il est bien connu. La région de canal 3, en combinaison avec la région 1B d'extension de la source, a été représentée comme occupant toute la distance entre la source 1A et les drains 4. La région 1B d'extension de la source est constituée par une matière donnant des ions porteurs minoritaires, tels que des ions phosphore implantés à une profondeur X au-dessous de la surface de substrat 8. La concentration en ions implantés fournit un moyen de commande direct du rendement d'injection et à un moindre degré, du mécanisme de recombinaison qui se produit entre les porteurs majoritaires créés par le processus d'ionisation par impact et les porteurs minoritaires injectés par l'émetteur 1B. En effet, la caractéristique de commande du rendement d'injection de la région 1B d'extension de la source de porteurs minoritaires a des effets déterminants sur le facteur de probabilité $\alpha$. Ceci est lié à la caractéristique de taux de recombinaison qui existe entre les drains et la source. La région implantée d'extension de la source génératrice de porteurs minoritaires est située au-dessous de la surface du substrat et s'étend sur une partie de la distance qui sépare la source des drains. Les porteurs majoritaires (trous) peuvent se recombiner dans la région 3a avec les porteurs minoritaires (électrons) injectés par la source, mais cette recombinaison se produit principalement dans la région 3c.

La région 1B d'extension de la source remplit ainsi à la fois une fonction de commande du rendement d'injection et une fonction de commande du taux de recombinaison et elle constitue un élément essentiel deu dispositif étant donné qu'elle constitue un moyen grâce auquel les conditions critiques d'avalanche entretenue représentées sur la figure 2 sont obtenues.

Lorsque les conditions critiques indiquées ci-dessus sont simultanément remplies, la condition critique d'avalanche représentée sur la figure 2 est obtenue. Si le produit du facteur de probabilité $\alpha$ par le facteur de multiplication M s'approche de 1 et est une fonction non linéaire du courant on obtient alors une caractéristique courant/tension de drain à résistance négative telle que représentée par la courbe (a) de la figure 1.

Un second paramètre critique pour ce dispositif est celui des moyens favorisant l'ionisation.

Comme représenté sur la figure 7B à laquelle on se référera, les moyens favorisant l'ionisation sont constitués, dans l'exemple représenté, par une mince région d'oxyde 6a emprisonnée entre une électrode accélératrice 7 et la surface 18 du canal semi-conducteur. Le champ électrique engendré entre l'électrode accélératrice 7 (normalement à la terre) et les régions de drain 4 accroît le champ qui existe déjà dans la région d'appauvrissement des drains 20. Ce champ déjà existant sera décrit ultérieurement. Comme déjà expliqué, les deux composantes de champ ont une grandeur suffisante, lorsqu'elles sont combinées, pour élever suffisamment la densité d'énergie du champ électrique dans la région située au voisinage des drains pour provoquer une ionisation par impact localisée.

*Considérations relatives à la géométrie des drains*

Le fonctionnement des modes de réalisation du transistor à tension d'avalanche commandée par l'effet $\alpha$ magnétiquement variable et du détecteur magnétiquement sensible représentés sur les figures dépend de la configuration du drain double pour le fonctionnement en détecteur magnétique, tel que celui représenté sur la figure 7A, par exemple. La largeur de la fente 16 entre les extrémités 17 des drains 4 est un facteur critique pour la détermination des performances optimales du dispositif. La fente 16 sépare les deux diffusions de drain de type N$^{++}$ 4 et est constituée par une matière de substrat de type P. Comme il résulte clairement de la figure 7A, une structure de type NPN existe entre les drains 4a et 4b.

Le potentiel de polarisation inverse (c'est-à-dire une tension positive appliquée à des drains de type N) appliqué simultanément aux drains 4a et 4b accroît l'étendue de la région d'appauvrissement 20 formée au voisinage des extrémités 17 des drains 4 et entourant les drains. Lorsque les limites de la région d'appauvrissement se déplacent vers l'extérieur en réponse à l'accroissement du potentiel des drains, la région de type P dans la fente 16 devient complètement appauvrie. Il est important pour le fonctionnement correct des dispositifs magnétiquement sensibles, tels que construits selon la présente invention, qu'une condition appelée "surappauvrissement" existe dans la région de la fente 16. Il est également important que cette condition se produise à un potentiel de drain qui est inférieur à celui auquel se produit la tension d'avalanche commandée. En d'autres termes, la région comprise entre les extrémités des drains doit être complètement appauvrie et, en fait, "surappauvrie" avant le moment où la tension d'avalanche commandée est atteinte pour la structure de transistor formée entre la source primaire 1A et les drains 4.

Les figures 9A à 9F représentent la formation des limites des zones d'appauvrissement au voisinage des deux diffusions de drain N$^{++}$ adjacentes qui sont séparées l'une de l'autre par une matière de type P ayant une largeur de fente S telle que représentée. Comme représenté par la série d'illustrations, les régions d'appauvrissement d'une largeur $l_p$ s'étalent ou croissent latéralement en réponse à l'accroissement de la tension simultanément appliquée aux deux drains 4. La région d'appauvrissement d'intérêt est celle qui se trouve dans la matière de type P située dans la région de la fente S.

La figure 9A représente les limites des zones d'appauvrissement formées à l'intérieur de la matière de type P qui entourent chacune des régions de drain comme conséquence naturelle de la dissemblance des matières des extrémités des drains et du substrat. Comme représenté par le diagramme d'intensité du champ électrique de la figure 9B, qui démontre, comme aussi les figures 9D et 9F, l'intensité du champ électrique E le long de la fente représenté directement au-dessous de la figure 9A et centré par rapport au centre de la fente S, il est créé dans la région d'appauvrissement un champ électrique qui est fonction de la distance entre la jonction PN stochastique et un point situé à l'intérieur de la zone d'appauvrissement $l_p$. Comme représenté, les limites des zones d'appauvrissement ne présentent aucune tendance à se chevaucher.

La figure 9C représente le déplacement vers l'extérieur ou croissance des limites des zones d'appauvrissement en réponse à un accroissement du potentiel de polarisation inverse appliqué aux diffusions de drain 4a et 4b. La situation critique a été représentée suivant laquelle les limites des zones d'appauvrissement se sont déplacées jusqu'au point de se toucher presque, comme représenté sur la figure 9C.

Les figures 9A et 9C représentent les conditions d'appauvrissement qui correspondent à un isolement électrique entre les deux régions de drain diffusées N$^{++}$.

Pratiquement, aucun courant électrique ne peut être conduit entre les deux diffusions dans le cas où une petite différence de potentiel est appliquée entre les drains lorsque la région d'appauvrissement existe de la manière représentée sur la figure 9A ou sur la figure 9C.

Cependant, la figure 9E représente une circonstance entièrement différente. Sur la figure 9E, les limites d'appauvrissement représentées correspondent à une condition dans laquelle il y a apparemment un contact ou un chevauchement des zones d'appauvrissement à l'intérieur de la région située à mi-distance des deux diffusions de drain. Dans cette condition, le champ électrique $E_0'$ auquel est soumise la jonction stochastique de chacune des diffusions $N^{++}$ aux emplacements où elles se font face et produit par une charge d'espace intervenant est insuffisant pour empêcher les électrons soumis à une agitation thermique de tenter de franchir la région d'appauvrissement qui sépare les diffusions de drain. En bref, dans cette condition, une conduction électrique peut se produire entre les diffusions de drain 4. Cependant, une différence de potentiel doit exister pour entretenir une telle conduction.

Le point P indiqué au centre exact des figures 9A à 9F se trouve exactement à mi-distance des drains 4. Dans le cas des circonstances correspondant aux limites des zones d'appauvrissement des figures 9A et 9C, le potentiel au point P, comme représenté sur les figures 9B et 9D, est essentiellement le même que celui de la source (non représentée), c'est-à-dire le potentiel de la terre. En d'autres termes, la quasi-totalité du potentiel des drains est développée au travers de la région d'appauvrissement séparant les extrémités des drains l'une de l'autre et de la région d'appauvrissement séparant les drains de la source. Cependant, le potentiel du point P n'est pas nul pour la condition correspondant à la situation représentée sur les figures 9E et 9F.

Les équations (5) et (6) ci-dessous donnent des expressions qui sont généralement utilisées dans la technique pour décrire la largeur de la couche d'appauvrissement $l_p$ à l'intérieur de la région de type P et le champ électrique maximal $E_0$ qui se produit à une jonction PN stochastique abrupte:

$$1_p = \sqrt{\frac{2\varepsilon_s}{q} \quad (\psi\text{-}V) \quad \frac{N_D}{N_A (N_D+N_A)}} \qquad (5)$$

$$|E_0| = \sqrt{\frac{2q}{\varepsilon_s} \quad (\psi\text{-}V) \quad \frac{N_A \cdot N_D}{N_A + N_D}} \qquad (6)$$

Les champs électriques au voisinage des deux drains qui correspondent respectivement aux conditions d'appauvrissement représentées sur les figures 9A, 9C et 9E ont été respectivement représentées sur les figures 9B, 9D et 9E. Les longeurs $1_p$ des zones d'appauvrissement ont tendance à se chevaucher comme représenté sur la figure 9E sur laquelle la longueur $1_p$ à l'avant de chacun des drains dépasse la moitié de la largeur S de la fente de sorte que le champ électrique à l'intérieur de la fente S est limité tandis que celui à l'avant des drains ne l'est pas. Le niveau de tension du point médian. $V_{mp}$, pour le point P situé à l'intérieur de la région de la fente S, est donné par l'équation (7) ci-dessous:

$$V_{mp} = V_D \frac{1}{4} E_0' S \qquad (7)$$

La valeur limite $E_0'$ est déterminée en utilisant l'équation (5) et l'équation (6).

Si l'on pose $l_p$ dans l'équation (5) égal à S/2 on obtient:

$$\left(\frac{S}{2}\right)^2 = \frac{2\varepsilon_s}{q} \quad (V_D\text{-}V_{mp}) \quad \frac{N_D}{N_A (N_D + N_A)} \qquad (8)$$

et le champ électrique $E_0'$ est obtenu au moyen l'equation (6):

$$E_0' = \sqrt{\frac{2_q}{\varepsilon_s} \quad (V_D\text{-}V_{mp}) \quad \frac{N_A \cdot N_D}{N_A + N_D}} \qquad (9)$$

En résolvant l'equation (8) par rapport à $(V_D\text{-}V_{mp})$ on obtient:

$$(V_D\text{-}V_{mp}) = \left(\frac{S}{2}\right)^2 \frac{q}{2\varepsilon_s} \quad \left(\frac{N_A (N_D + N_A)}{N_D}\right) \qquad (10)$$

En remplaçant, dans l'équation (9), le terme $(V_D\text{-}V_{mp})$ par l'expression correspondante de l'équation (10) on obtient:

$$E_0' = \frac{q}{2\varepsilon_s} \quad \dot{S} \quad N_A \qquad (11)$$

En substituant l'équation (11) dans l'équation (7) on obtient l'équation désirée pour la tension du point médian:

$$V_{mp} = V_D - \frac{1}{8} S^2 \frac{q}{\varepsilon_s} N_A \qquad (12)$$

La concentration maximale en accepteurs, $N_A$, qui permet juste le chevauchement critique des zones d'appauvrissement peut être trouvée en fixant la tension $V_{mp}$ du point médian de l'equation (12) égale à 0. Ainsi, la concentration équivalente Nea en accepteurs ou la concentration maximale en accepteurs qui peut être utilisée dans le dispositif, dans la zone située entre les drains, pour une tension donnée des drains $V_D$ et une largeur donnée S de la fente 16 est donnée par l'equation (13):

$$N_{eq} = \frac{8 V_D \varepsilon_s}{qs^2} \qquad (13)$$

La concentration équivalente en accepteurs, $N_{eq}$, correspond à la condition de largeur d'appauvrissement critique et sera utilisée ultérieurement pour déterminer la concentration en trous qui peut s'écouler dans la région de la fente lorsque l'ionisation par impact se produit. La concentration critique en accepteurs fournit la base pour le calcul de l'impédance d'ionisation de drain à drain $R_{dd}$.

L'équation (12) donne l'expression désirée pour la tension du point médian $V_{mp}$ lorsque la condition de chevauchement des zones d'appauvrissement se produit. L'équation (12) est applicable chaque fois que la tension des drains $V_D$ est supérieure à:

$$\frac{N_A \, q \, S^2}{8\varepsilon_s}$$

Autrement, la tension du point médian, $V_{mp}$ est essentiellement nulle. Comme il résulte clairement de l'équation (12) la tension du point médian s'approche de la tension des drains dans le cas où les matières du substrat ont une concentration suffisamment basse en accepteurs, $N_A$, (matières à resistivité élevée pour un étroit espacement S entre les drains). Une tension du point médian non nulle est essentielle pour la sensibilité et le fonctionnnement du dispositif détecteur magnétique.

L'impédance d'ionisation de drain à drain $R_{dd}$ est déterminée pour le dispositif de la figure 7A de la manière suivante:

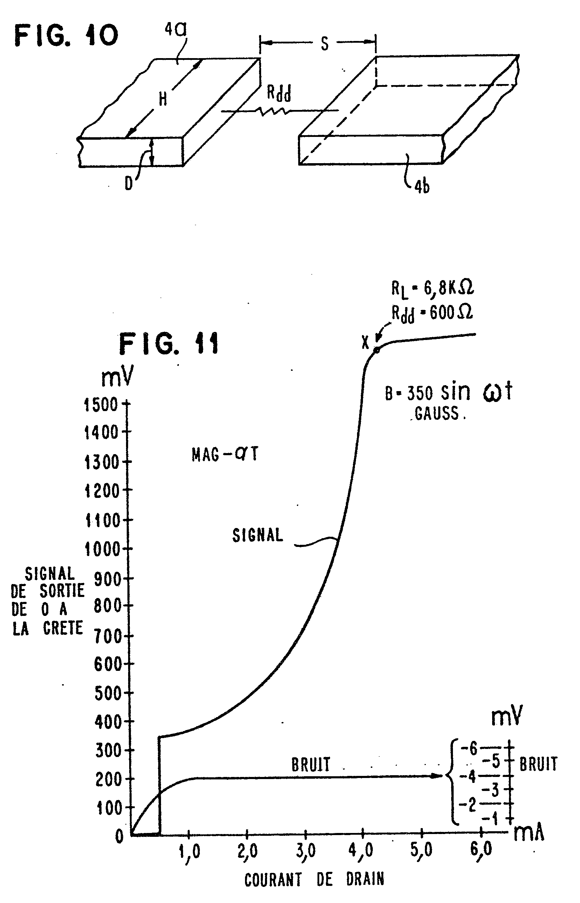

Comme représenté sur la figure 10, deux drains 4a et 4b sont séparés d'une distance S, les drains ayant une hauteur ou profondeur D et une largeur H, comme représenté.

A partir des premiers principes de physique, la résistance de drain à drain $R_{dd}$ est donnée par l'équation (14):

$$R_{dd} = \frac{S}{\sigma HD} \qquad (14)$$

dans laquelle:

$$\sigma = N_H q \mu \qquad (15)$$

et

$$NH = (N_{eq} - N_A) \qquad (16)$$

En substituant les équations (15) et (16) dans l'équation (14), on obtient:

$$R_{dd} \cong \frac{S}{(N_{eq} - N_A) \, q \, \mu \, HD} \qquad (17)$$

dans laquelle:
$N_{eq}$ est donnée par l'équation (9);
$N_A$ est la concentration en accepteurs du substrat;
H est la largeur du drain;
D est la hauteur ou profondeur du drain;
S est la largeur de la fente entre les drains;
$\mu$ est la mobilité des porteurs majoritaires; et
q est la charge électrique élémentaire.
En utilisant l'équation (17) on voit que l'impédance de la source de commande différentielle du dispositif détecteur magnétique est très faible, comme les calculs le montrent. La faible impédance de drain à drain explique l'important rapport signal/bruit et la caractéristique de tension de sortie en courant continu presque équilibrée des dispositifs de ce type. Une faible impédance de la source de commande est également utile pour réduire au minimum les effets des capacités parasités qui pourraient autrement limiter les capacités en haute fréquence du détecteur.

*Caractéristiques de performances typiques d'un dispositif magnétiquement variable*

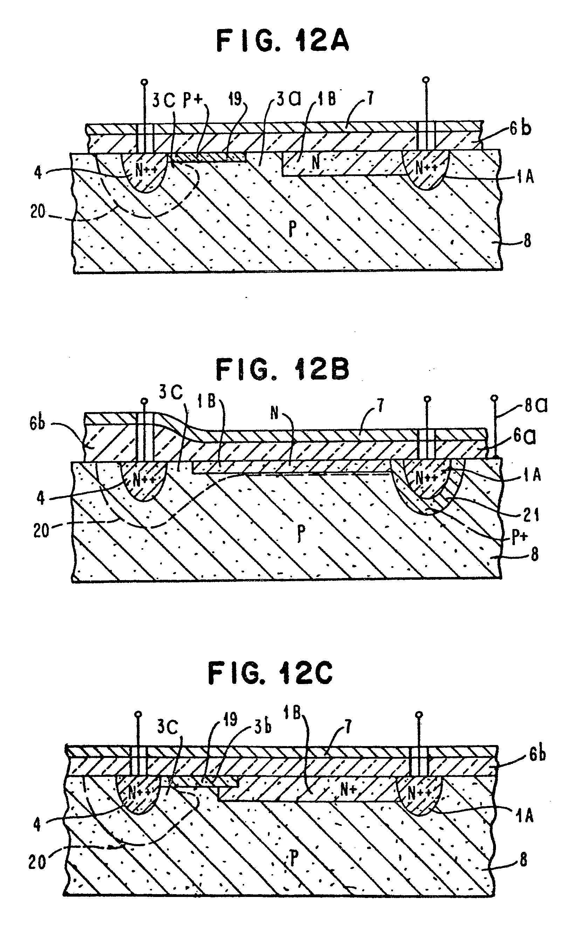

On a fabriqué et essayé un grand nombre de transistors magnétiquement sensibles du type qui fait l'objet de l'invention. Un volume important de données expérimentales a été recueilli et certaines de ces données présentent des caractéristiques remarquables qui méritent d'être examinées. La figure 11 représente le comportement du signal différentiel c'est-à-dire du signal différentiel de drain à drain et le bruit produit mesurés en utilisant un détecteur utilisant une matière de substrat en silicium de type P ayant une résistivité de deux ohms-cm. L'axe des ordonnées de gauche est désigné signal de sortie différentiel de zéro à la crête (en mV), ce signal étant mesuré à 60 Hz en utilisant une source de champ magnétique sinusoïdal produisant un champ de crête de 350 gauss. Le courant de drain (en mA) est indiqué en abscisse. L'axe des ordonnées de droite indique, en millivolts, la tension de bruit de crête en sortie qui correspond aux mêmes valeurs de courant de drain que celles du signal de sortie dont la tension est reportée sur l'axe des ordonnées de gauche. La largeur de bande du bruit a été limitée à un mégahertz.

La réponse du signal typique s'accroît brusquement à approximativement 500 microampères de courant de drain puis s'accroît rapidement avec l'accroissement du courant de drain jusqu'à ce qu'un point de saturation, désigné par la référence X sur la figure 11, soit atteint. Le point de saturation X correspond au point d'inflexion de la courbe courant/tension de drain de la figure 2. La saturation du signal se produit, pour un champ d'excitation donné, chaque fois que le rendement d'injection de la région d'extension de la source ne suit plus le courant de drain. Ceci peut correspondre à une condition dans laquelle la recombinaison des trous et des électrons commence à se produire dans la région de type P non appauvrie qui entoure la région d'appauvrissement. Les porteurs majoritaires qui se recombinent à l'extérieur de la région d'appauvrissement ne contribuent pas au signal de réponse au champ magnétique mais seulement au courant de drain. Il peut être désirable de faire fonctionner un tel détecteur magnétique à un niveau de courant de drain juste au-dessus du niveau de saturation de la recombinaison (de la couche d'appauvrissement) afin de supprimer les changements de sensibilité du dispositif dûs aux variations de la tension d'alimentation des drains $V_{DD}$.

Il est important de noter que le niveau de bruit est essentiellement constant sur toute la plage de fonctionnement utile du dispositif. On a trouvé que la source principale de bruit était celle produite par l'injection statistique par la source de porteurs minoritaires et par la recombinaison en surface de ces porteurs. Un moyen grâce auquel ce dernier phénomène peut être réduit consiste à créer un canal à porteurs minoritaires d'environ 50 nm (500 Å) au-dessous de la surface du substrat. Une réduction du bruit d'un facteur de deux ou davantage a été obtenue en pratique de cette manière.

La caractéristique d'amplitude constante du bruit est attribuée à l'impédance d'ionisation de drain à drain $R_{dd}$ représentée dans l'équation (17). Cette impédance diminue lorsque le courant du canal s'accroît, atténuant ou réduisant le signal de bruit d'une manière exactement proportionnelle à sa génération. Comme représenté sur la figure 11, le signal de sortie caractéristique du détecteur magnétique utilisé pour obtenir les valeurs spécifiques indiquées a été construit et utilisé de la manière indiquée dans le tableau ci-dessous. La technique de construction utilisée est une technique classique d'intégration à grande échelle utilisant des processus de photolithographie et de gravure avec des implantations ioniques et des diffusions pour créer les diverses zones conductrices dans le substrat, tous ces procédés étant des procédés bien connus des spécialistes de la technique.

| | | |
|---|---|---|
| Epaisseur d'oxyde sous l'activeur | = | 0,1 micron |
| Largeur S de la fente | = | 1,2 microns |
| Largeur H des drains | = | 2,5 microns |
| Profondeur D des drains | = | 0,8 micron |
| Matière du substrat | = | silicum de type P ayant une résistivité de 2 Ω-cm |
| Longueur L de la source aux drains | = | 25 microns |
| Largeur du canal $W_C$ | = | 12,5 microns |
| Tension d'avalanche | = | 28 V |
| Tension de l'électrode accélératrice | = | tension de la masse |
| Résistances de charge | = | 6,8 kΩ |
| $R_{dd}$ (mesure au point X, figure 11) | = | 600 Ω |
| Concentration en donneurs des drains et de la source | = | $10^{20}.cm^{-3}$ |
| Résistance de la région d'extension de la source | = | 150 Ω |

On a déterminé expérimentalement que la sensibilité du dispositif détecteur magnétique dépend principalement de la concentration accepteurs du substrat qui a des effets très importants sur la longueur de la région d'appauvrissement à l'avant des drains. La sensibilité de ces dispositifs a été mesurée sur des échantillons fabriqués en utilisant des résistivités du substrat comprises entre 0,1 et 50 ohms-cm. On a trouvé une relation expérimentale qui reflète la sensibilité comme indiqué par l'équation (18).

$$\text{Sensibilité } S = K \left(\frac{N_H}{N_A}\right)^{3/2} \quad (18)$$

exprimée en millivolts par gauss-mégahertz.

Equation dans laquelle:

$$N_H = (N_{eq} - N_A)$$
$$N_{eq} = Eq. (13) \quad (19)$$
$$K = 0,04$$

*Mécanisme de fonctionnement théorique*

Le transistor à tension d'avalanche commandée par l'effet alpha magnétiquement variable ou la combinaison de transistor magnétiquement sensible peut être théoriquement analysé conformément à un mécanisme de fonctionnement hypothétique. Avec quelconques efforts, on peut démontrer que le courant de collecteur $I_C$ qui s'écoule dans une configuration de transistor bipolaire montée en émetteur commun fonctionnant à l'intérieur de la région de claquage par avalanche est défini de la manière indiquée par l'équation (20).

$$I_c = \frac{M}{1-\alpha M} \; [I_B + I_{c_0}] \qquad (20)$$

L'équation (20) peut être simplifiée pour la configuration spéciale du détecteur magnétique qui permet à la base (contact du substrat) de ne pas être connecté, c'est-à-dire de flotter avec $I_B = 0$. Cette configuration est essentiellement un dispositif à trois bornes ayant deux collecteurs (drains) et un unique émetteur (source).

La simplification donne l'équation suivante:

$$I_c = \frac{M I_{c0}}{1-\alpha M} \qquad (21)$$

L'équation d'approximation la plus simple proposée pour décrire la tension d'avalanche est donnée par l'équation (22):

$$V_{MA} = V_{CB_0} \, (1-\alpha M)^{1/N} \, (1-1/M)^{1/N} \qquad (22)$$

dans laquelle:

M est le facteur de multiplication d'avalanche;

$V_{CB_0}$ est la valeur de tension donnée par les équations (3) et (4);

N est l'exposant d'avalanche et a une valeur numérique typique de 3,0;

$\alpha$ $= \gamma\alpha_T$ le facteur de probabilité de recombinaison où

$\gamma$ = le facteur de rendement d'injection;

$\alpha_T$ = le facteur de rendement de transport.

L'equation (22) peut être simplifiée pour décrire le comportement de dispositif dans la région qui présente de l'intérêt dans le cas où M >> 1 et $\alpha$ << 1.

$$V_{MA} = V_{CB_0 \, (1-\alpha M)}^{1/N} \qquad (23)$$

Le rythme de variation de la tension d'avalanche magnétique (TAM) en fonction d'un champ magnétique B, appliqué perpendiculairement à la région active du canal est donné par l'équation (24). L'équation (24) est tirée de l'équation (23):

$$\frac{d(V_{MA})}{dB} = -\frac{V_{MA}}{N(1-M\alpha)} [M_o \frac{\delta\alpha}{\delta B} + \alpha_o \frac{\delta M}{\delta B}] \qquad (24)$$

dans laquelle:

$M_o$ est la valeur du facteur de multiplication d'avalanche (M) pour un champ magnétique nul;

$\alpha_o$ est la valeur du facteur $\alpha$ pour un champ magnétique nul.

Il est possible d'obtenir une tension de sortie du signal magnétique maximale sans modulation du courant de drain. On peut comprendre cette caractéristique de dispositif en examinant les effets de la ligne de charge horizontale 11A (résistance de charge infinie) représenté sur la figure 4B.

En différentiant le courant de drain $I_c$ (equation 21) par rapport au champ magnétique B, on obtient:

$$\frac{dI_c}{dB} = \frac{\frac{dM}{dB} + M^2 \frac{d\alpha}{dB}}{(1-\alpha M)^2} (I_{c_0}) \qquad (25)$$

Pour la situation correspondante à la ligne de charge horizontale MA de la figure 4B:

$$\frac{DI_c}{dB} = 0.$$

Si l'on pose l'équation (25) égale à 0, on obtient alors une expression intéressante:

$$\frac{dM}{dB} = -M^2 \frac{d\alpha}{dB}$$

$$RL \to \infty \qquad (26)$$

$$\alpha M \neq 1$$

Léquation (26) spécifie que le facteur de multiplication d'avalanche M est modulé par un champ magnétique et est lié à la modulation du facteur $\alpha$ par le facteur $-M^2$. La modulation de la multiplication d'avalanche peut être un aspect important à prendre en considération lorsqu'on tient compte de cet effet sur la modulation du rendement d'injection localisée de la source.

En substituant l'expression

$$\frac{dM}{dB}$$

de l'équation (26) dans l'équation (23) on obtient l'équation suivante:

$$\frac{d(V_{MA})}{dB} = \frac{-V_{MA}}{N} [M_o \frac{d\alpha}{dB}] \qquad (27)$$

$$R_L \to \infty$$

L'équation (27) indique simplement qu'à la limite (résistances de charge de résistance élevée), le signal de réponse au champ magnétique obtenu du dispositif est le résultat de la modulation du facteur de probabilité $\alpha$ par un champ magnétique. La sensibilité magnétique $S_m$ du dispositif peut être obtenue en manipulant l'équation (27). Le résultat est donné par l'équation (28):

$$s_m = \frac{d(V_{MA})}{V_{MAo}} = -\frac{M_o \, \alpha_o}{N} \left(\frac{d\alpha}{\alpha_o}\right) \quad (28)$$

$$R_L \rightarrow \infty$$

L'equation (28) définit la sensibilité de la modulation magnétique de la tension à un drain du dispositif. Le dispositif est normalement utilisé dans le mode différentiel. La sensibilité différentielle $S_{MD}$ qui comprend les effets de l'impédance de charge est données par l'equation (29):

$$S_{MD} = -\frac{2M_o \, \alpha_o}{N} \left(\frac{d\alpha}{\alpha_o}\right) \frac{R_L}{R_L + R_{DD}} \quad (29)$$

Le terme $\alpha$ utilisé dans les équations ci-dessus est habituellement défini dans les ouvrages de base comme étant le produit $\gamma\alpha_T$ dans lequel $\gamma$ est le rendement d'injection de la source (émetteur) et $\alpha_T$ est le facteur de rendement de transport. Dans la littérature technique, le facteur de rendement du transport $\alpha_T$ est habituellement défini par rapport à une configuration de transistor bipolaire monté en base commune. Le facteur de transport $\alpha_T$ est un facteur de probabilité qui est utilisé ici pour définir les performances du dispositif. Il est égal à la probabilité qu'un porteur minoritaire injecté soit fourni avec succès à la région de multiplication proche des drains. La probabilité de ce évènement est très faible si l'on considère la densité des trous qui quittent la région des drains et se déplacent vers la source. On rappelera que les trous (porteurs majoritaires) sont engendrés par le processus d'ionisation par impact. Lorsque les trous retournent vers la source, il existe de fortes chances qu'une recombinaison électrons-trou se produise. Le coefficient de rendement de transport $\alpha_T$ est le produit de trois coefficients de probabilité:

$$\alpha_T = P_1 \, P_2 \, P_3 \quad (30)$$

équation dans laquelle:

$P_1$ est la probabilité qu'un porteur minoritaire injecté par le contact de la source atteigne l'extrémité de la région d'extension de la source (point A de la figure 7B) avant de se recombiner avec un porteur majoritaire engendré par l'ionisation par impact. Ce coefficient est généralement proche de l'unité.

$P_2$ est la probabilité qu'un électron quittant la région à l'extrémité (électron émis dans la jonction PN) de la région d'extension de la source (jonction émissive) réussisse à traverser avec succès la région de commande du rendement de transport et atteigne le bord de la région d'appauvrissement formée au voisinage des drains. La longueur de cette région est déterminée par la longueur totale L entre la source (émetteur) et le ou les drains (collecteurs) et varie inversement par rapport au coefficient de probabilité $P_2$. Cette région constitue la zone de commande du rendement de transport primaire.

$P_3$ est la probabilité qu'un électron entrant à travers le bord de la région d'appauvrissement atteigne la région de multiplication dans la région d'appauvrissement au voisinage de la jonction stochastique formée au niveau des diffusions de drain. Cette région est la zone de recombinaison dominante dans laquelle la plupart des recombinaisons se produisent.

On estime que les facteurs de probabilité $P_1$ et $P_2$ sont relativement insensibles à la modulation par les champs magnétiques du fait des vitesses de glissement relativement faibles des porteurs à l'intérieur de leurs régions respectives. Cependant, le facteur de probabilité $P_3$ est très susceptible d'être modulé par un champ magnétique. Les porteurs majoritaires (trous) et les porteurs minoritaires (électrons) se déplacent essentiellement à la vitesse de saturation $V_s = 10^7$ cm/s à l'intérieur de la région d'appauvrissement entourant les extrémités des drains. Dans ces circonstances, les porteurs répondent facilement à une force de Lorentz $F = (q.V_x)xB$. Le facteur de probabilité $P_3$ ne concerne que les évènements qui se produisent à l'intérieur de la région d'appauvrissement. Compte tenu des explications qui précèdent et de la définition du facteur $\alpha$, $\alpha=\gamma\alpha_T$, le terme

$$\frac{d\alpha}{dB}$$

de l'équation (27) peut être défini en fonction de $P_1$, $P_2$, $P_3$ et $\gamma$.

$$\frac{d\alpha}{dB} = \gamma \frac{d\alpha_T}{dB} + \alpha_T \frac{d\gamma}{dB} \cong \gamma P_1 \, P_2 \, \frac{dP_3}{dB} + \alpha_T \frac{d\gamma}{dB} \quad (31)$$

En substituant l'équation (31) dans l'equation (28) qui définit la sensibilité, on obtient:

$$Sm = -\frac{M_0 \cdot \alpha_0}{N} \left(\frac{d\alpha_T}{\alpha_T} + \frac{d\gamma}{\gamma}\right) \simeq \frac{M_0 \quad \alpha 0}{N} \left(\frac{dP_3}{P_3} + \frac{d\gamma}{\gamma}\right) \qquad (32)$$

L'équation (32) réflète cette situation que la sensibilité magnétique peut ne pas être due uniquement à la déviation des porteurs à l'intérieur de la région d'appauvrissement. Le rendement d'injection $\gamma$ peut également être modifié par l'accroissement ou la diminution de la concentration en porteurs majoritaires le long des côtés et de la surface inférieure de la région d'extension de la source. On doit noter que les trajectoires statistiques des trous et celles des électrons sont toutes deux déviées dans le même sens par l'action d'une force de Lorentz.

Le facteur de probabilité est inversement proportionnel à la longueur de la couche d'appauvrissement $l_p$ donnée par l'équation (5). En accroissant la résistivité du substrat, on accroît la longueur de la couche d'appauvrissement. Cette action abaisse le facteur de probabilité $P_3$ tout en accroissant simultanément le pourcentage de changement dans $P_3$ dû à l'action de Lorentz sur les trous et les électrons. Les détails de la déviation des porteurs par la force de Lorentz et de la redistribution résultante du potentiel dans la zone d'appauvrissement est un mécanisme subtil qui n'a pas encore été élucidé.

Il est essentiel que le produit $M\alpha$ ait une valeur en régime permanent inférieure à l'unité et de préférence d'environ 0,5. Sinon, la sensibilité magnétique n'a pas une valeur maximale. En général, le facteur $\alpha$ est l'objet de changements qui sont fonction du courant de drain. Cependant, un choix soigneusement établi de la résistivité, de la longueur et de la forme de la région d'extension de la source permet au produit $M\alpha$ de rester essentiellement constant et à sa valeur critique sur la totalité d'un intervalle important de courant de drain. Ces conditions optimales varient en fonction de la résistivité du substrat qui est utilisée.

Un autre procédé utilisable pour commander la valeur en régime permanent du produit $M\alpha$ pourrait consister à utiliser le contact (8a, figure 7B) du substrat. En plaçant une résistance entre la source et le contact du substrat, on réalise un moyen efficace pour abaisser le rendement d'injection de la source. La résistance de shunt est réglée pour une valeur de fonctionnement du courant de drain quelconque de telle sorte que la réponse au signal magnétique est accrue au maximum. Cette configuration de dispositif est appelée dispositif à quatre bornes. La sensibilité du dispositif à quatre bornes est quelque peu inférieure à celle de la configuration préférée à trois bornes.

*Autres modes de réalisation de transistors magnétiquement sensibles*

Les figures 12A à 12C sont des vues en coupe d'autres modes de réalisation de dispositifs magnétiquement sensibles. Les vues en plan de ces dispositifs seraient approximativement semblables à celle de la figure 7A avec les différences indiquées dans la description ci-après.

La différence principale entre les variantes représentées sur les figures 12A et 12C et les dispositifs représentés sur les figures 7A, 7B et 8 réside en ce que la région de commande du rendement de transport et les moyens favorisant l'ionisation ne s'étendent que sur une partie de la distance entre la source 1A et les drains 4. Les figures 12A et 12C sont similaires et représentent les effets obtenus en utilisant une technique d'implantation double, c'est-à-dire que les moyens favorisant l'ionisation et les moyens de commande du rendement de transport sont fabriqués au moyen d'une technique d'implantation ionique. Les moyens 19 favorisant l'ionisation et commandant le rendement de transport sont constitués par une matière de type $P^+$ peu profonde formée par implantation d'ions bore. La région implantée favorisant l'ionisation s'étend à partir des drains 4 sur une partie de la distance en direction de la source 1A. La concentration utile en accepteurs à l'intérieur de la région implantée 19 d'activeur doit être supérieure à la concentration en accepteur de la matière de substrat environnante. Comme indiqué par l'équation (6) ci-dessus, le champ électrique au niveau de la jonction PN stochastique située à l'extrémité de chaque drain s'accroît en proportion de la racine carrée de la concentration en accepteurs, $N_A$, pour une tension de drain donnée. L'ionisation par impact ne se produit au niveau des drains qu'au voisinage de l'implantation 19 favorisant l'ionisation. La raison de ce phénomène est que dans les conditions de claquage, le champ électrique, à l'intérieur de la région d'appauvrissement de la zone implantée 19 favorisant l'ionisation, est nettement supérieur au champ qui existe à l'intérieur de la matière de substrat de type P qui entoure les extrémités des drains. L'ionisation par impact ne se produit qu'à une tension d'avalanche commandée donnée, comme décrit par l'équation (8) et au voisinage des drains sur les côtés de ces derniers qui font face à la source 1A et correspondent à la jonction stochastique $P^+N^{++}$.

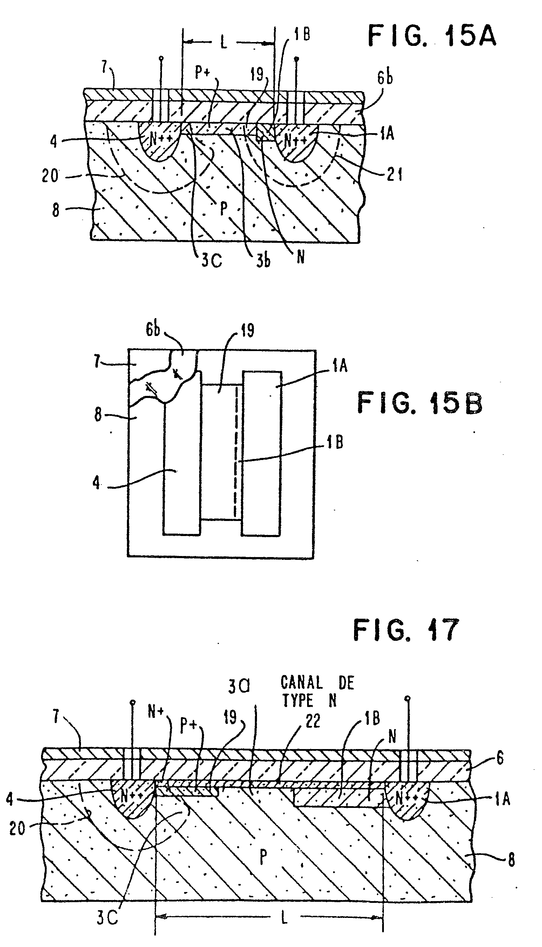

L'implantation de bore 19 peut, alternativement, être une implantation profonde, c'est-à-dire une implantation qui s'étend sur toute le hauteur ou profondeur des drains, formant ainsi un canal conducteur entre l'émetteur et les drains. Si cette disposition est réalisée, l'implantation remplit simultanément trois fonctions. En premier lieu, l'implantation sert de région favorisant l'ionisation; en second lieu, elle sert de moyen de commande du rendement de transport, et en troisième lieu elle sert de moyen permettant de modifier le rendement d'injection si elle s'étend jusqu'au voisinage de l'interface de l'émetteur. L'implantation profonde peut être recouverte d'une mince couche implantée 22 (Fig. 17) de matière de type N+ pour créer un isolement de la zone conductrice principale par rapport à la surface du substrat afin de réduire les effets de la recombinaison superficielle et le bruit résultant qu'elle produit. Cette technique est extrêmement efficace pour construire des dispositifs magnétiques très sensibles en utilisant des matières de substrat à résistivité élevée. c'est-à-dire des matières ayant une résistivité supérieure à 1 ohm-cm. Dans de telles circonstances, le rendement d'injection est normalement trop grand et doit être réduit au moyen d'une poche P+, comme décrit ici ou au moyen de la technique d'implantation d'un canal P+ profond qui vient d'être décrite. La longueur et la résistivité de la région $L_2$ que cette implantation occupe sur la figure 18, commande, naturellement, le rendement de transport dans cette zone et sert également d'activeur d'ionisation et de commande du rendement d'injection. La fonction de commande du rendement d'injection est un résultat du changement de concentration en accepteurs de porteurs minoritaires à l'interface entre l'implantation et l'émetteur, à l'extrémité de la région d'extension de la source.

On a également représenté sur la figure 12A une région d'extension de la source 1B qui sert d'émetteur et qui constitue la région implantée de commande du rendement d'injection. A la différence du dispositif représenté sur la figure 12C, cette région d'implantation ne s'étend, à partir de la source 1A, que sur une partie de la distance entre la source et les drains. Cette région d'extension de la source ou région de commande d'injection est plus profonde que la région 19 favorisant l'ionisation et est obtenue en implantant des ions phosphore à un niveau d'énergie nettement supérieur à celui utilisé pour implanter la région 19 favorisant l'ionisation. Dans le sens utilisée dans la présente discussion, les régions "profondes" s'étendent sur une distance supérieure à 1 micron au-dessous de la surface du substrat et les régions "peu profondes" ont une épaisseur comprise entre 100 mm (1000 Å) et 0,1 micron.

La figure 12B représente un dispositif détecteur magnétique qui comporte une poche 21 de matière du type P+ formée autour de la zone de diffusion de source N++. Une telle poche pourrait être également utilisée pour entourer la région d'extension de la source, comme représenté sur la figure 18. Cette région P+ autour de la source est utile pour commander le potentiel de la règion du substrat par rapport à celui de la source. Ceci a un effet important sur le rendement par injection de la source d'émission de porteurs minoritaires dans le semi-conducteur. Il est essentiel pour le fonctionnement correct du détecteur magnétique que le potentiel du substrat (base) soit supérieur au potentiel de la source. Le potentiel nominal désiré pour cette tension, dans le cas où la matière du substrat est du silicium ayant une résistivité de 2 ohms-cm, est d'approximativement 700 millivolts. Des procédés alternatifs sont disponibles pour garantir que le potentiel critique substrat-source est atteint.

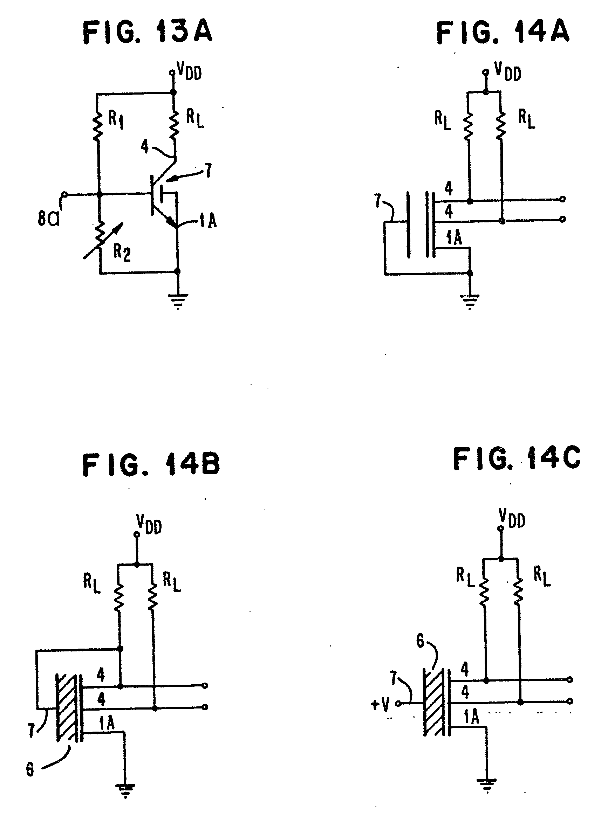

Un procédé nécessite l'emploi d'un contact de substrat séparé 8A et d'une quatrième borne, comme représenté sur la figure 13A, qui est utilisée pour polariser activement ou passivement la jonction substrat-source à la valeur optimale. Sur la figure 13A, les résistances $R_1$ et $R_2$ sont utilisées à cette fin. Cependant, en choisissant convenablement la géométrie du dispositif et les conditions d'implantation pour l'activeur d'ionisation et les régions de canal de commande de durée de vie et pour une résistivité donnée du substrat, il est possible d'obtenir ce potentiel critique de la jonction substrat-source dans la plage de 600 à 800 millivolts sans utiliser une quatrième borne 8a. En d'autres termes, le dispositif peut être rendu automatiquement polarisant. Le mode de réalisation préféré du détecteur magnétique est la configuration auto-polarisante ou à trois bornes ayant deux contacts de drain et un contact de source.

La figure 12C représente un dispositif similaire à celui représenté sur les figures 8 et 12A dans lequel les moyens favorisant l'ionisation (activeur) sont constitués par une région 19 implantée avec des ions bore. La région d'extension de la source a été représentée comme s'étendant à partir de la source 1A le long d'une partie de la distance en direction des drains et comme touchant l'implantation 19 favorisant l'ionisation par impact.

Pendant le fonctionnement de la configuration de détecteur magnétique décrite ici, l'électrode accélératrice ou électrode écran 7 qui favorise l'ionisation peut être connectée à la source 1A (à la terre) à l'un des drains 4 ou à une source quelconque de potentiel. Ces situations ont été représentées sur les figures 14A à 14C.

Lorsqu'on fait fonctionner le dispositif de la figure 7A avec un potentiel appliqué à l'électrode accélératrice 7 qui est à un niveau supérieur au potentiel de seuil du transistor à effet de champ du dispositif, on crée une couche d'inversion dans la surface du substrat située au-dessous de l'électrode. La couche d'inversion peut repousser le canal de recombinaison des porteurs majoritaires au-dessous de la surface et cette disposition s'est avérée réduire efficacement le bruit de la recombinaison superficielle.

Essentiellement, la même réduction du bruit de recombinaison superficielle peut être obtenue en implantant un canal peu profond

19

d'ions phosphore (porteurs minoritaires) s'étendant sur au moins une partie de la distance entre la source et les drains. La dose et l'énergie d'implantation sont réglées pour créer la même concentration en porteurs à la surface du canal que celle qui existe à l'intérieur de la couche d'inversion créée par l'action d'une tension de porte. Une telle configuration a été représentée sur la figure 17 qui montre un canal à porteurs minoritaires 22 qui s'étend sur toute la distance entre la source 1A et le drain 4.

*Caractéristiques du transistor limiteur de tension*

Les caractéristiques fondamentales pour un transistor à tension d'avalanche limiteur de tension du type envisagé dans la présente invention ont déjà été données. Le transistor limiteur de tension nécessite que trois conditions structurales fondamentales soient simultanément remplies.

En d'autres termes, les moyens favorisant l'ionisation par impact doivent s'étendre sur au moins une partie de la distance entre le drain et la source et la région de canal intrinsèque à résistivité élevée, qui peut être ou est appauvrie, doit être formée à l'intérieur du semi-conducteur de façon à s'étendre sur au moins une partie de la distance entre le drain et la source. La région d'appauvrissement occupe une zone ayant une profondeur finie au-dessous de la surface de la région semi-conductrice qui sépare le drain (collecteur) de la source (émetteur). La région appauvrie conduit les porteurs majoritaires (des trous dans le cas des dispositifs NPN) créés par l'action de l'ionisation et elle peut être contiguë aux moyens favorisant l'ionisation et s'étendre au-dessous de ces moyens.

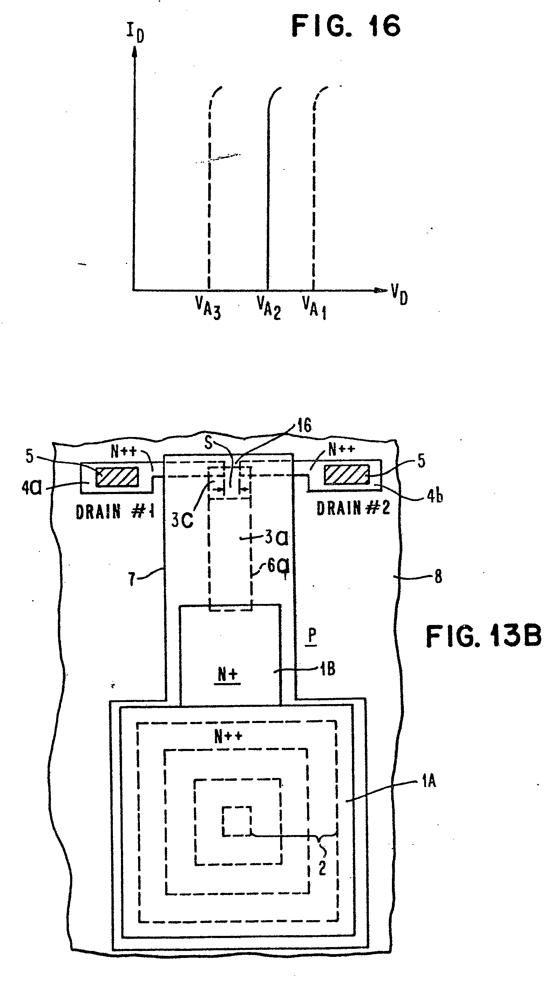

Les figures 15A, 15B représentent un procédé utilisable pour remplir ces conditions afin de former un transistor limiteur de tension. Comme représenté sur les figures 15A et 15B, un drain 4 et une source 1A sont introduits par diffusion dans une matière de substrat 8 à résistivité relativement élevée. La source 1A et son extension 1B, d'une part, et le drain 4 (collecteur), d'autre part, sont tous deux formés avec une matière de type N fortement dopée et sont espacées l'une de l'autre d'une distance L. La région 1B est dopée à une concentration en accepteurs différente de celle de la source 1A et du drain 4. Ceci commande la résistivité de la région de commande du rendement d'injection. La matière du substrat est une matière de type P ayant une résistivité relativement élevée, à savoir de 5 ohms-centimètre. Des moyens 19 favorisant l'ionisation par impact sont constitués par des ions bore implantés à une profondeur d'approximativement 100 $\mu$m (1000 Å) et ayant une concentration en accepteurs, $N_A$, nettement supérieure à celle de la matière du substrat 8. Un écran conducteur 7 a été représenté sur la figure 15A comme étant séparé du substrat par une couche d'oxyde 6b relativement épaisse. L'écran 7 empêche le rayonnement électromagnétique de frapper la région située entre la source 1A et le drain 4. L'application d'un potentiel de polarisation inverse au drain 4 provoque l'extension d'une couche d'appauvrissement 20 à partir du drain au-dessous de la région 19 favorisant l'ionisation sur une partie de la distance en direction de la diffusion de source 1A polarisée dans le sens direct. La longueur de la région d'appauvrissement formée au niveau du drain au voisinage des moyens 19 favorisant l'ionisation est relativement courte. Le champ électrique dans cette région, en particulier au niveau de la jonction PN stochastique, est suffisamment élevé pour qu'il en résulte que l'ionisation par impact localisée ne se produise qu'à cet emplacement. La quasi totalité des trous engendrés par le processus d'ionisation par impact retournent à la source à l'intérieur de la région d'appauvrissement 20 au-dessous des moyens 19 favorisant l'ionisation. Les propriétés de claquage par avalanche de ce dispositif ont été représentées sur la figure 2 et reprises sur la figure 16.

Comme on peut le voir en se référant à la figure 16, diverses propriétés de tension de claquage par avalanche $V_{A1}$, $V_{A2}$, $V_{A3}$ peuvent être obtenues en modifiant le choix de la concentration en accepteurs implantés dans la couche 19 favorisant l'ionisation. La figure 16 représente également le caractéristique d'avalanche à impédance nulle obtenue en satisfaisant la condition qu'une majorité des trous qui se recombinent se produisent dans la région d'appauvrissement 20. Si ceci n'était pas le cas, le produit du facteur de probabilité $\alpha$ par le facteur de multiplication de l'ionisation, M, ne serait par proche de l'unité. Naturellement, ces dispositifs présentent également une sensibilité aux champs magnétiques qui est néanmoins mieux utilisé dans la configurations à deux drains.

Une poche 21 du type $P^+$ peut être utilisée pour enfermer la diffusion de source en tant que moyen pour abaisser le rendement d'injection de la source lorsque des substrats ayant une résistivité élevée sont utilisés.

Sur la figure 18, on a représenté un mode de réalisation préféré qui montre tous les aspects critiques des conditions que doit remplir le dispositif magnétiquement sensible et ses éléments fonctionnels. Un substrat en silicium 8 est muni de diffusions de source et de drains de type $N^{++}$, fortement dopées désignées respectivement par les références 1A, 4a et 4b. Une commande du rendement d'injection est assurée au moyen d'une région 1B d'extension de la source ayant un dopage $N^+$ plus faible. Une région de commande ou de réglage du rendement de transport 3a et 3b est également prévue. On notera que la longueur critique totale L est composée des longueurs $L_1$, $L_2$ et $L_3$. $L_1$ est la longueur de la région de commande du rendement d'injection. $L_2$ est la longueur de la région de commande du taux de recombinaison et $L_3$ est la longueur de la région d'appauvrissement dans laquelle la totalité de l'ionisation et la plus grande partie de la recombinaison se produisent. On a également représenté une poche 21 de type $P^+$ qui sert à réduire le bruit et à commander, en partie, le rendement d'injection. Dans la région 3a qui est située à l'intérieur de la région de la poche 21 de type $P^+$, une certaine commande de recombinaison peut être réalisée en modifiant la longueur de la zone. La plus grande partie de la commande de recombinaison peut être obtenue dans la zone 3b. La longueur de la partie $L_2$ est commandée en modifiant la longueur totale L de façon à obtenir le facteur de recombinaison $\alpha$ désiré de la manière décrite en détail ci-dessus et constitue la région de commande du rendement de transport primaire.

On a donné ci-après une liste des diverses caractéristique critiques du dispositif et indiqué une valeur nominale pour chacune de ces caractéristiques indiquées sur la figure 18.

Les extrémités des drains sont désignées régions 4a et 4b. Ces régions sont diffusées et ont typiquement une profondeur de 0,8 micron, une largeur de 2,5 microns et elles présentent une résistivité de 80 ohms par carré. La fente 16 (S) est la distance de séparation entre les drains et a typiquement une longueur S de 1,2 microns.

La largeur $W_1$ définit l'étendue transversale de la région de canal ou d'oxyde mince 3 qui s'étend à partir de la région 1B d'extension de la source et intercepte les drains 4a, 4b. Une valeur typique de la largeur $W_1$ est de 7,62 microns. La largeur $W_2$ de la région d'extension de la source est typiquement double de la largeur de la région 3 du canal.

$L_1$ est la longueur de la région d'extension 1B de la source et on peut la modifier pour commander sa résistance. La résistance dépend également de la résistivité de la matière utilisée pour sa fabrication. Un rapport longueur/largeur $L_1/W_2$ de 1,3 pour la région d'extension de la source s'est avéré donner de bons résultats.

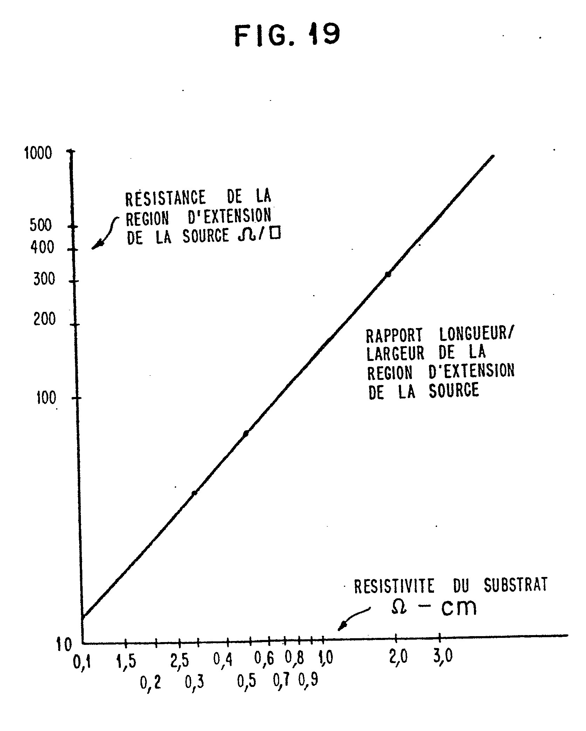

La figure 19 est un graphique sur lequel on a tracé la courbe de la résistance critique requise, en ohms par carré, de la région d'extension 1B de la source en fonction de la résistivité du canal 3 ou du substrat 8, en admettant un rapport longueur/largeur de 1,3. Si l'impédance de la région d'extension de la source est trop faible pour une résistivité donnée du substrat ou du canal, on obtient une propriété d'avalanche à résistance négative. Il est bien entendu que la résistance par carré est la résistance d'un carré de matière, dont la longueur $L_1$ et la largeur $W_2$ sont donc égales $(L_1/W_2 = 1)$. Résistance en ohms

$$= \frac{\rho}{T}$$

$L_1/W_2$ où T est l'épaisseur de la couche.

La longueur $L_2$ du canal 3 est également importante pour l'obtention des propriétés critiques des caractéristiques courant/tension d'avalanche représentées sur les figures 4A, 4B. Cette région commande le rendement de transport et elle a une longueur nominale d'environ 20, 32 microns dans le cas où la région d'extension de la source a une rapport longueur/largeur égale à 1,3. Un dopage à l'or peut être utilisé dans cette région pour accroître la densité des dislocations et diminuer ainsi le rendement de transport et permettre ainsi de raccourcir la longueur $L_2$. La longueur $L_6$ est légèrement plus longue que la longueur de la longueur de la région de source fortement dopée 1A. Pour permettre l'établissement d'un bon contact électrique avec la zone de diffusion de la source, cette région doit avoir une résistance d'environ 10 ohms par carré. La longueur de cette région est à peu près égale à la longueur $L_1$ de la région d'extension de la source.

La longueur $L_3$ est la longueur de la région d'appauvrissement formée à l'avant des extrémités 4a et 4b des drains. La longueur de cette couche d'appauvrissement obéit à l'équation (5).

La largeur de la région de source 1A a été désignée $W_4$ et elle peut être rendue égale à la largeur $W_2$ de la région 1B d'extension de la source. La largeur $W_3$ de l'électrode 7 doit être supérieure à la largeur $W_2$ de la région 1B d'extension de la source.

L'électrode 7 doit s'étendre sur toute la longueur de la structure, comme représenté sur la figure 18 et, comme représenté, elle peut faire partie intégrante de la zone de contact 2.

La région 21 de la figure 18 est constituée par une matière du type à porteurs majoritaires qui forme une poche dans laquelle la matière de la source et la matière de la région d'extension de la source peuvent être placées, lorsqu'elle est utilisée. La résistivité de la poche 21 doit être inférieure à la résistivité du substrat 8 et égale à approximativement 0,5 ohms-cm. Comme représenté sur la figure 18, la région 21 s'étend au-delà de la région 1B d'extension de la source sur une distance $L_5$. La longueur $L_5$ est typiquement égale à la moitié de la distance $L_2$.

On doit insister en ce qui concerne l'équation (1) ci-dessus, sur le fait que le produit $M.\alpha$ doit rester essentiellement constant sur un intervalle important du courant de drain. Lorsque le produit $M.\alpha$ est maintenu indépendant du courant de drain (collecteur), les caractéristiques courant/tension verticales désirées sont obtenues, comme représenté sur la figure 2, la figure 4A, la figure 4B, et la figure 16. Dans ces circonstances le dispositif à deux drains des figures 7A, 13B et 18 présente la sensibilité magnétique la plus grande.

Le facteur de probabilité de recombinaison électron-trou $\alpha$ a été défini comme étant le produit du rendement d'injection $\gamma$ par le facteur de rendement de transport $\alpha_T$, c'est-à-dire que $\alpha = \gamma\alpha_T$. Le rendement d'injection est typiquement inférieur à l'unité et est commandé par la région 1B d'extension de la source définie comme étant la région de commande du rendement d'injection. Le rendement d'injection est proportionnel au pourcentage des porteurs minoritaires injectés à travers l'extrémités de la région 1B qui fait face aux drains par rapport à l'injection totale autour de la surface de la région 1B en contact avec la matière du type à porteurs majoritaires qui l'entoure. Le rendement d'injection est inversement proportionnel à la résistance longitudinale de la région 1B et à la concentration en accepteurs de la matière dans laquelle cette région est placée. La résistance longitudinale de la région d'injection commandée est déterminée par sa longueur, sa largeur, sa profondeur et la concentration en donneurs de porteurs minoritaires utilisés dans sa fabrication.

Le facteur de transport $\alpha_T$ (équation 30) a été défini comme étant le produit de trois facteurs de probabilité $P_1$, $P_2$ et $P_3$. Le facteur de probabilité $P_1$ est commandé par la région 1B. La recombinaison à l'intérieur de cette région est, cependant, très petite et elle a peu d'effet sur la commande du facteur de transport $\alpha_T$. Le facteur de probabilité $P_2$, cependant, est inversement proportionnel à la longueur $L_2$ (figure 18) et à la concentration en accepteurs de porteurs minoritaires, $N_A$, de cette région. Les deux paramètres $L_2$ et $N_A$ peuvent être commandés par les caractéristiques de construction du dispositif pour modifier le facteur de probabilité $P_2$ et accroître ou réduire de la manière désirée le produit M.$\alpha$. Le facteur de probabilité $P_3$ décrit des évènements qui se produisent dans la région d'appauvrissement (longueur $L_3$ de la région 3c, figure 18). Ce facteur de probabilité peut être très petit et il s'approche de la valeur 1/M aux drains, M étant le facteur de multiplication du courant d'avalanche. Le facteur de probabilité $P_3$ est une fonction du courant de drain et de la tension d'avalanche $V_{MA}$. Etant donné que l'on désire que la tension $V_{MA}$ soit indépendante du courant, le facteur de probabilité $P_3$ est un évènement spontané et ne peut pas, par conséquent, être commandé indépendamment par des paramètres physiques du dispositif.

Cependant, le rendement d'injection $\gamma$ et les facteurs de probabilité $P_1$ et $P_2$ influencent effectivement le taux de recombinaison qui produit le rendement de transport net observé à l'intérieur de la région d'appauvrissement. Ces facteurs sont, par conséquent, les principaux moyens utilisables pour optimiser le comportement du dispositif.

On a déterminé expérimentalement que la sensibilité magnétique du dispositif à deux drains des figures 7A, 13B et 18 s'accroissait d'une manière inversement proportionnelle à la concentration en accepteurs de la région 3c. Pour obtenir une sensibilité magnétique très élevée, il est désirable d'utiliser des substrats ayant une forte résistivité, typiquement supérieure à 2 ohms-cm. Lorsqu'on utilise des substrats à résistivité élevée, on perd la capacité d'accroître et de réduire le produit M.$\alpha$ du fait de l'accroissement du rendement d'injection $\gamma$ et du facteur de probabilité $P_2$.

Pour résoudre le problème posé par cette situation on utilise la région de poche de type P$^+$ 21, figure 18. Cette poche a été représentée comme entourant complètement les deux régions de source 1A et 1B et comme occupant environ la moitié de la région 3 entre l'extrémité de la région 1B d'extension de la source et les drains 4. La commande du facteur de probabilité $P_2$ est regagnée dans la région 3a et la commande du rendement d'injection $\gamma$ est regagnée par la condition de limite de séparation N$^+$ P$^+$ formée autour de la jonction PN de la région d'extension de la source. L'utilisation de la technique de formation d'une poche P$^+$ permet de commander convenablement le produit M.$\alpha$ dans le cas où le substrat a une résistivité élevée et elle fournit simultanément un moyen pour accroître la sensibilité magnétique. Lorsqu'on utilise la technique de formation d'une poche P$^+$, la distance $L_4$ (figure 18) doit être au moins égale à la longueur $I_d$ de la couche d'appauvrissement formée au niveau des drains, sinon l'utilisation d'un substrat à résistivité élevée perd son intérêt. La poche P$^+$ est introduite dans le substrat en utilisant les techniques d'implantation ionique. Une profondeur d'environ 3 microns est appropriée et est obtenue en laissant l'implantation diffuser grâce à l'emploi d'un profil temps-températures de recuit approprié. Une poche P$^+$ qui présente une résistivité de 0,5 ohms-cm représente un compromis raisonnable.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention, et il est bien entendu que de nombreux autres moyens peuvent être utilisés pour réaliser la commande du rendement d'injection, la commande du rendement de transport et l'activation de l'ionisation par impact à la place de ceux décrits ici sans sortir du cadre des revendications annexées.

**Revendications**

1. Transistor conçu pour fonctionner dans un mode brusquement conducteur de génération de courant d'avalanche stable entretenu à faible impédance, et comprenant:

un corps (8) en une matière semi-conductrice d'un premier type de porteurs majoritaires;

au moins une source (1A) en une matière semi-conductrice d'un second type de porteurs majoritaires, opposé à celui du corps (8), pour injecter dans le corps une quantité de porteurs électriques du type minoritaire pour le corps, cette source (1A) étant en contact électriquement conducteur avec le corps;

un premier contact (2) électriquement conducteur disposé sur la source afin de connecter cette dernière à une source de potentiel électrique;

au moins un drain (4) en une matière semi-conductrice du type de porteurs majoritaires opposé à celui du corps (8) pour conduire les porteurs minoritaires injectés et ceux engendrés par avalanche hors du corps, ce drain (4) étant en contact électriquement conducteur avec le corps (8) et étant situé en un emplacement séparé de la source (1B);

un second contact (5) électriquement conducteur disposé sur le drain (4) afin de connecter ce dernier à une source de potentiel électrique, ce transistor étant caractérisé en ce qu'il comprend:

une région intrinsèque ou à forte résistivité (20) qui peut être ou est effectivement appauvrie, qui est formée à l'intérieur du semi-conducteur dans une région qui s'étend sur au moins une partie de la distance entre le drain (4) et la source (1B), cette région intrinsèque ayant une profondeur finie au-dessous de la surface de la région semi-conductrice qui sépare le drain (4) et la source (1B);

des moyens de commande du rendement d'injection (1B; 19, 21) pour commander le taux d'injection de porteurs minoritaires par la source (1A) dans le corps (8);

des moyens de commande du rendement de transport (1B; 19) pour commander le taux de fourniture au voisinage du drain (4) des porteurs minoritaires en réglant le taux de recombinaison des porteurs minoritaires et des porteurs majoritaires se produisant dans la région entre la source (1A) et le drain (4); et

des moyens favorisant l'ionisation par impact (6a; 7; 19) pour faciliter les ruptures localisées des liaisons covalentes dans le corps (8) au voisinage du drain (4), ces moyens favorisant l'ionisation accroissant la densité d'énergie dans le corps (8) dans ledit voisinage et produisant le courant d'avalanche à une tension d'avalanche caractéristique ($V_{MA}$) entretenue entre la source (1A) et le drain (4) par l'application d'un potentiel électrique suffisant aux premier et second contacts (2, 5); et en ce que les moyens de commande du rendement d'injection (1B; 19; 21) et les moyens de commande du rendement de transport (1B; 19) sont construits de façon à produire des rendements d'injection ($\gamma$) et de transport ($\alpha_T$) qui, lorsque leur produit ($\alpha$) est multiplié par le facteur de multiplication (M) du courant d'avalanche, donnent un produit (M.$\alpha$) qui est en régime permanent inférieur à l'unité.

2. Transistor selon la revendication 1, caractérisé en ce que le produit des rendements d'injection et de transport et du facteur de multiplication du courant d'avalanche (M.$\alpha$) a une valeur voisine de 0,5.

3. Transistor selon l'une quelconque des revendications 1 et 2 caractérisé en ce que les moyens favorisant l'ionisation par impact comprennent:

une zone de matière électriquement conductrice (7) recouvrant une partie du corps (8) au moins au voisinage du drain (4) et séparée de la surface du corps par un isolant électrique (6a), cette matière conductrice (7) étant raccordée à une source de potentiel électrique à un niveau établi par rapport au potentiel appliqué au premier contact (2) de façon à créer un champ électrique entre la zone de matière conductrice et le drain (4), ce champ accélérant les porteurs minoritaires émis par la source (1A) en direction du drain (4) et accroissant également la densité d'énergie audit voisinage du drain à un niveau qui facilite les ruptures par ionisation par impact des liaisons covalentes de la matière du corps par les porteurs minoritaires pour produire le courant d'avalanche.

4. Transistor selon la revendication 3 caractérisé en ce que:

la zone de matière électriquement conductrice (7) s'étend à partir d'un emplacement situé au-dessus d'une région située au voisinage immédiat du drain (4) sur au moins une partie de la distance en direction de la source (1A), cette zone conductrice (7) étant située plus proche de la surface du corps (8) au voisinage du drain (4) qu'au dessus d'autres régions du corps (8).

5. Transistor selon l'une quelconque des revendications 1 à 4 caractérisé en ce que les moyens favorisant l'ionisation par impact comprennent, en outre:

une région (19) ayant une plus forte concentration en accepteurs de porteurs minoritaires que le corps (8) qui l'entoure et disposée dans le corps au moins au voisinage du drain (4).

6. Transistor selon l'une quelconque des revendications 1 à 5 caractérisé en ce que les moyens de commande du rendement d'injection comprennent:

des moyens pour établir une différence de potentiel électrique entre le premier contact (2) et le corps (8) dans un sens qui modifie le potentiel de polarisation directe qui existe entre le premier contact (2) et le corps (8).

7. Transistor selon l'une quelconque des revendications 1 à 5 caractérisé en ce que les moyens de commande du rendement d'injection comprennent:

une région en forme de poche (21) entourant la source (1A) dans laquelle la concentration en accepteurs de porteurs minoritaires est plus forte que dans le corps (8).

8. Transistor selon l'une quelconque des revendications 1 à 7 caractérisé en ce que les moyens de commande du rendement d'injection comprennent:

des moyens pour établir un gradient de potentiel entre la surface limite, par rapport au corps (8), de la source (1B) et le premier contact (2) en créant une résistance interne commandée entre eux.

9. Transistor selon l'une quelconque des revendications 1 à 8 caractérisé en ce qu'il est sensible à un champ magnétique perpendiculaire au plan de la surface du corps (8) et comporte:

au moins deux drains (4a, 4b), ces drains étant séparés l'un de l'autre d'une distance (S) qui est inférieure à la distance (L) qui les sépare de la source (1A), ces drains (4a, 4b) étant disposés symétriquement par rapport à une ligne qui joint le milieu de la distance (S) les séparant au centre de la source, cette ligne coupant en son milieu les moyens favorisant l'ionisation par impact (6a, 7; 19) et définissant une ligne centrale d'une zone conductrice qui s'étend à partir de la source (1A) jusqu'aux drains (4a, 4b).

**Patentansprüche**

1. Transistor für abrupt leitende Betriebsart unter Erzeugung eines bei niedriger Impedanz unterhaltenen stabilen Lawinenstroms, enthaltend:

einen Körper (8) aus einem Halbleiter eines ersten Majoritätsträgertyps,

wenigstens einen Emitter (1A) aus einem Halbleiter eines zweiten, dem des Körpers (8) entgegengesetzten Majoritätsträgertyps zur Injektion einer Anzahl von für den Körper elektrische Minoritätsträger bildenden Ladungsträgern in den Körper, wobei dieser Emitter (1A) in elektrisch leitendem Kontakt mit dem Körper steht,

eine erste auf dem Emitter angebrachte Elektrode (2) zum Anschließen an eine elektrische Potentialquelle,

wenigstens einen Kollektor (4) aus einem Halbleiter eines dem Körper (8) entgegengesetzten Majoritätsträgertyps, um die injizierten und die durch Lawinen-Effekt erzeugten Majoritätsträger aus dem Körper herauszuleiten, wobei dieser Kollektor (4) mit dem Körper (8) in elektrisch leitendem Kontakt steht und sich an einer vom Emitter (1A) abgesonderten Stelle befindet,

eine zweite auf dem Kollektor (4) angebrachte Elektrode (5) zum Anschließen an eine elektrische Potentialquelle,

gekennzeichnet sowohl durch:

eine eigenleitende oder hochohmige Zone (20), die wirkungsvoll verarmt sein kann oder ist und im Halbleiterinnern in einem zumindest sich über einen Teil des Abschnitts zwischen Kollektor (4) und Emitter (1A) erstreckenden Bereich gebildet ist, wobei diese eigenleitende Zone unterhalb der Oberfläche der den Kollektor (4) vom Emitter (1A) trennenden Halbleiterzone eine begrenzte Tiefe hat,

Maßnahmen (1B, 19, 21) zur Steuerung des Injektionswirkungsgrads, um auf die Minoritätsträger-Injektionsrate vom Emitter (1A) in den Körper (8) einzuwirken,

Maßnahmen (1B, 19) zur Steuerung des Transportfaktors, um auf die Minoritätsträger-Zufuhrrate in die unmittelbare Umgebung des Kollektors (4) durch Einstellen der Rekombinationsrate von sich im Bereich zwischen Emitter (1A) und Kollektor (4) ergebenden Minoritäts- und Majoritätsträgern einzuwirken und

Maßnahmen (6a, 7, 19) zum Begünstigen der Stoßionisation, um im Körper (8) sich in unmittelbarer Umgebung des Kollektors vollziehendes Aufbrechen kovalenter Bindungen zu erleichtern, indem diese Maßnahmen zum Begünstigen der Stoßionisation die Energiedichte im Körper (8) in besagter Umgebung erhöhen und den Lawinenstrom mit einer zwischen Emitter (1A) und Kollektor (4) durch Anlegen ausreichender elektrischer Potentiale an der ersten und zweiten Elektrode (2, 5) aufrechterhalten, charakteristischen Lawinenspannung ($V_{MA}$) erzeugen;

als auch durch eine derartige Auslegung der Maßnahmen (1B, 19, 21) zur Injektionswirkungsgradsteuerung und der Maßnahmen (1B, 19) zur Transportfaktorsteuerung, daß sich ein derjeniger Injektionswirkungsgrad (Y) und ein derjeniger Transportfaktor ($\alpha$T) einstellen, welche beim Multiplizieren ihrer Produktes ($\alpha$) mit dem Multiplikationsfaktor (M) des Lawinenstroms zu einem ständig unterhalb von eins liegenden Produkt (M$\alpha$) führen

2. Transistor nach Anspruch 1, dadurch gekennzeichnet, daß das Produkt aus Injektions-Wirkungsgrad, Transportfaktor und Multiplikationsfaktor des Lawinenstroms (M$\alpha$) einen Wert von etwa 0,5 aufweist.

3. Transistor nach Anspruch 1 und/oder 2, dadurch gekennzeichnet, daß die Mittel zur Begünstigung der Stoßionisation eine elektrisch leitende Auflage (7) aufweisen, die einen Teil des Körpers (8) wenigstens in unmittelbarer Umgebung des Kollektors (4) überdeckt und von der Körperoberfläche durch elektrische Isolation (6a) getrennt ist, indem diese leitende Auflage (7) mit einem sich bezüglich des an die erste Elektrode (2) angelegten Potentials ergebenden Pegels derart an eine elektrische Potentialquelle angeschlossen ist, daß sich sowohl ein elektrisches Feld zwischen der elektrisch leitenden Auflage und dem Kollektor (4) zur Beschleunigung der vom Emitter (1A) in Richtung des Kollektors (4) ausgehenden Minoritätsträger ausbildet als auch die Energiedichte in besagter Umgebung des Kollektors auf ein derartiges Niveau erhöht, daß das Stoßionisationsbedingte Aufbrechen der kovalenten Bindungen des Körpermaterials durch die Minoritätsträger zur Lawinenstromerzeugung erleichtert wird.

4. Transistor nach Anspruch 3, dadurch gekennzeichnet, daß sich die elektrisch leitende Auflage (7) von einer Stelle oberhalb eines in unmittelbarer Umgebung des Kollektors befindlichen Bereichs über wenigstens einen Teil des Abstands zum Emitter (1A) erstreckt, indem sich diese leitende Auflage (7) in unmittelbarer Umgebung des Kollektors näher an der Körperoberfläche befindet als oberhalb anderer Stellen des Körpers (8).

5. Transistor nach einem der Ansprüche 1 bis 4, dadurch gekennzeichnet, daß die Maßnahmen zur Begünstigung der Stoßionisation außerdem einschließen:

eine Zone (19) mit gegenüber der des sie umgebenden Körpers (8) erhöhter Konzentration der Minoritätsträger-Akzeptoren und einer im Körper zumindest in unmittelbarer Umgebung des Kollektors vorgesehenen Lage.

6. Transistor nach einem der Ansprüche 1 bis 5, dadurch gekennzeichnet, daß die Maßnahmen zur Steuerung des Injektionswirkungsgrades Mittel zum Einstellen einer elektrischen Potentialdifferenz zwischen erster Elektrode (2) und Körper (8) enthalten, so daß hierdurch das zwischen erster Elektrode (2) und Körper (8) wirksame Potential in Vorwärtsrichtung bedingt ist.

7. Transistor nach einem der Ansprüche 1 bis 5, dadurch gekennzeichnet, daß die Maßnahmen zur Steuerung des Injektionswirkungsrades eine taschenförmige, den Emiter (1A) umgebende Zone aufweisen, in der die Konzentration der Minoritätsträger-Akzeptoren stärker ist als im Körper (8).

8. Transistor nach einem der Ansprüche 1 bis 7, dadurch gekennzeichnet, daß die Maßnahmen zur Steuerung des Injektionswirkungsgrades Mittel zum Einstellen eines Potentialgradienten zwischen der mit Bezug auf den Körper (8) vorliegenden Grenzfläche des Emitters (1A), und der ersten Elektrode (2) enthalten, indem so ein einstellbarer Innenwiderstand hierzwischen herbeigeführt wird.

9. Transistor nach einem der Ansprüche 1 bis 8, dadurch gekennzeichnet, daß er auf ein senkrecht zur Oberflächenebene des Körpers (8) gerichtetes magnetisches Feld anspricht und zumindest zwei Kollektoren (4a, 4b) in einem solchen Abstand (S) zueinander enthält, der kleiner als der Abstand (L) zwischen Kollektoren und Emitter (1A) ist, welche symmetrisch zu einer die Mittelinie einer sich vom Emitter (1A) bis zu den Kollektoren (4a, 4b) erstreckenden, leitenden Zone definierenden Linie liegen, die den Mittelpunkt des Abstands (S) mit dem Mittelpunkt des Emitters verbindet, indem diese Linie in ihrer Mitte die die Stoßionisation begünstigenden Mittel (6a, 7, 19) schneidet.

## Claims

1. A transistor for operation in an abruptly conducting, low impedance sustained, stable avalanche current generation mode, comprising:

a body (8) of a first majority carrier type semiconductive material;

at least one source (1A) of a second majority carrier type semiconductive material of opposite type to that of body (8) for injecting into said body a supply of electrical carriers of the minority type for said body, said source (1A) being in electrically conductive contact with said body;

a first electrically conductive contact (2) on said source for connection thereof to an electrical potential supply;

at least one drain (4) of a majority carrier type semiconductive material of opposite type to that of body (8) for conducting injected and avalanche-generated minority carriers from said body, said drain (4) being in electrically conductive contact with body (8) and located at a position separated from source (1B);

a second electrically conductive contact (5) on said drain (4) for connection thereof to an electrical potential supply

said transistor being characterized in that it includes:

an intrinsic or high resistivity region (20) which can be or is effectively depleted, formed within the semiconductor, in a region which covers at least a portion of the distance between drain (4) and source (1B), said intrinsic region having a finite depth below the surface of the semiconductive region separating drain (4) and source (1B);

injection efficiency control means (1B; 19, 21) for controlling the rate of minority carrier injection from source (1A) into body (8);

transportation efficiency control means (1B; 19) for controlling the rate of delivery of minority carriers to the vicinity of drain (4) by adjusting the recombination rate of the minority and majority carriers occurring in the region between source (1A) and drain (4); and

impact ionization promoter means (6a; 7; 19) for facilitating localized covalent bond ruptures in body (8) in the vicinity of drain (4), said ionization promoter means increasing the energy density in body (8) in said vicinity and producing the avalanche current at a characteristic avalanche voltage ($V_{MA}$) sustained between source (1A) and drain (4) by the application of a sufficient electrical potential to said first and second contacts (2, 5);

and in that injection efficiency control means (1B; 19; 21) and transportation efficiency control means (1B; 19) are constructed to produce injection ($\gamma$) and transportation ($\alpha_T$) efficiencies which, when their product ($\alpha$) is multiplied by multiplying factor (M) of the avalanche current, result in a product (M.$\alpha$) which is less than unity in steady state.

2. A transistor as described in claim 1, characterized in that the product of the injection and transportation efficiencies and of the avalanche current multiplying factor (M.$\alpha$) has a value close to 0.5.

3. A transistor as described in claim 1 or 2, characterized in that the impact ionization promoter means comprises:

an area of electrically conductive material (7) overlying a portion of body (8) at least in the vicinity of drain (4) and spaced apart from the surface of the body by an electrical insulator (6a) said conductive material (7) being connected to a source of electrical potential at a level referenced with respect to that potential applied to first contact means to create an electric field between the area of conductive material and drain (4), said electric field accelerating the minority carriers emitted from source (1A) towards drain (4) and also raising the energy density in said vicinity of the drain to a level which facilitates impact ionization ruptures of the covalent bonds of the body material by the minority carriers to produce the avalanche current.

4. A transistor as described in claim 3, characterized in that:

the area of electrically conductive material (7) extends from a position overlying a region in the immediate vicinity of drain (4) over at least part of the distance towards source (1A), said area of conductive material (7) being closer to the surface of body (8) in the vicinity of drain (4) than over other regions of body (8).

5. A transistor as described in any one of claims 1 to 4, characterized in that the impact ionization promoter means further comprise:

a region (19), having a higher minority carrier acceptor concentration than body (8) surrounding it and in the body at least in the vicinity of drain (4).

6. A transistor as described in any one of claims 1 to 5, characterized in that the injection efficiency control means comprise:

means for establishing an electrical potential difference between first contact means (2) and body (8) in a direction altering the forward bias potential occurring between first contact means (2) and body (8).

7. A transistor as described in any one of claims 1 to 5, characterized in that the injection efficiency control means comprise:

a pocket-shaped region (21) surrounding source (1A) in which the minority carrier acceptor concentration is higher than in body (8).

8. A transistor as described in any one of claims 1 to 7, characterized in that the injection efficiency control means comprise:

means for establishing a potential gradient between the surface boundary with respect to body (8), of source (1B) and first contact (2) by producing a controlled internal resistance therebetween.

9. A transistor as described in any one of claims 1 to 8, characterized in that it is responsive to a magnetic field perpendicular to the plane of the surface of body (8) and comprises:

at least two drains (4a, 4b) said drains being separated from one another by a distance (S) which is less than distance (L) separating them from source (1A), said drains (4a, 4b) being symmetrically arranged with respect to a line joining the centre of the distance (S) and the centre of the source (1A), said line bisecting impact ionization promoter means (6a; 7; 19) and defining a centre line of a conductive zone extending from source (1A) to drains (4a, 4b).

# FIG. 1

# FIG. 2

**FIG. 3**

**FIG. 5**

SORTIE

CIRCUIT
EQUIVALENT

FIG. 6

FIG. 8

FIG. 4A

FIG. 4B

4

# FIG. 7A

# FIG. 7B

REGION D'APPAUVRISSEMENT

FIG. 9A

FIG. 9B

FIG. 9C

FIG. 9D

FIG. 9E

FIG. 9F

FIG. 10

FIG. 11

$R_L = 6,8 K\Omega$
$R_{dd} = 600\Omega$

$B = 350 \sin \omega t$ .GAUSS.

MAG$-\alpha$T

SIGNAL

SIGNAL DE SORTIE DE 0 A LA CRETE

BRUIT

BRUIT

COURANT DE DRAIN

## FIG. 12A

## FIG. 12B

## FIG. 12C

FIG. 13A

FIG. 14A

FIG. 14B

FIG. 14C

# FIG. 16

# FIG. 13B

FIG. 15A

FIG. 15B

FIG. 17

# FIG. 18

# FIG. 19

RÉSISTANCE DE LA REGION D'EXTENSION DE LA SOURCE $\Omega/\Box$

RAPPORT LONGUEUR/ LARGEUR DE LA REGION D'EXTENSION DE LA SOURCE

RESISTIVITE DU SUBSTRAT $\Omega - cm$